(19) Europäisches Patentamt / European Patent Office / Office européen des brevets

(11) **EP 3 816 640 B1**

(12) **EUROPEAN PATENT SPECIFICATION**

(45) Date of publication and mention of the grant of the patent:
**12.10.2022  Bulletin 2022/41**

(21) Application number: **19920240.9**

(22) Date of filing: **30.07.2019**

(51) International Patent Classification (IPC):
**G01R 29/24** *(2006.01)*      **B05B 5/00** *(2006.01)*

(52) Cooperative Patent Classification (CPC):
**B05B 5/025; A01M 7/0096; G01M 99/008;**
B05B 14/00; B05B 15/40

(86) International application number:
**PCT/CN2019/098340**

(87) International publication number:
**WO 2020/186682 (24.09.2020 Gazette 2020/39)**

(54) **CHARGE-TO-MASS RATIO MEASUREMENT SYSTEM FOR ELECTROSTATIC ATOMIZING SPRAY NOZZLE AND MEASUREMENT METHOD THEREFOR**

LADUNGS-MASSE-VERHÄLTNIS-MESSSYSTEM FÜR EINE ELEKTROSTATISCHE ZERSTÄUBUNGSDÜSE UND MESSVERFAHREN DAFÜR

SYSTÈME DE MESURE DE RAPPORT CHARGE SUR MASSE POUR BUSE DE PULVÉRISATION PAR ATOMISATION ÉLECTROSTATIQUE ET PROCÉDÉ DE MESURE ASSOCIÉ

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority:  **15.03.2019  CN 201910196052**

(43) Date of publication of application:
**05.05.2021  Bulletin 2021/18**

(73) Proprietor: **Jiangsu University**
**Zhenjiang, Jiangsu 212013 (CN)**

(72) Inventors:
• **OU, Mingxiong**
**Zhenjiang, Jiangsu 212013 (CN)**
• **WU, Minmin**
**Zhenjiang, Jiangsu 212013 (CN)**
• **JIA, Weidong**
**Zhenjiang, Jiangsu 212013 (CN)**
• **GONG, Chen**
**Zhenjiang, Jiangsu 212013 (CN)**
• **ZHOU, Huitao**
**Zhenjiang, Jiangsu 212013 (CN)**

(74) Representative: **Laufhütte, Dieter**
**Lorenz Seidler Gossel**
**Rechtsanwälte Patentanwälte**
**Partnerschaft mbB**
**Widenmayerstraße 23**
**80538 München (DE)**

(56) References cited:
CN-A- 104 237 974      CN-A- 105 676 010
CN-A- 108 459 213      CN-A- 109 975 623
CN-U- 208 137 933      JP-A- H05 345 905

EP 3 816 640 B1

**Description**

**Technical Field**

The present invention relates to a system for measuring a charge-to-mass ratio of an electrostatic atomization nozzle and a measurement method using the same, and in particular, to a system for measuring a charge-to-mass ratio of an electrostatic atomization nozzle and a measurement method using the same, which are capable of measuring in real time and monitoring the charge-to-mass ratio parameter of the electrostatic atomization nozzle, wherein the measurement system is applicable to real-time measurement and monitoring of the charge-to-mass ratio parameter of the electrostatic atomization nozzle in agricultural plant protection spraying, industrial electrostatic spraying, and other fields.

**Background**

The electrostatic atomization technology is a liquid atomization spraying technology widely applied in agricultural plant protection spraying, electrostatic spraying, electrostatic atomization spray combustion, industrial electrostatic precipitation, and other fields. The electrostatic atomization nozzle developed based on the electrostatic atomization technology features small spray flow, fine particle size, uniform droplets, easy adsorption to the target, good backside adhesion effect, and so on. Especially in the technical field of mechanical pesticide spraying for agricultural plant protection, agricultural plant protection spraying machines using the electrostatic atomization nozzles generally have the advantages of pesticide saving, water saving, high working efficiency, and good pest control effects. Therefore, the electrostatic atomization nozzles are widely used in products such as knapsack sprayers, stretcher-mounted sprayers, mist sprayers, and orchard sprayers. The charge-to-mass ratio parameter is a key indicator of the product performance of the electrostatic atomization nozzles, and has an important influence on the spraying effect of the electrostatic atomization nozzles. See for example CN 105 676 010 A.

A conventional device for measuring the charge-to-mass ratio mainly uses a Faraday cylinder or grid as a droplet collection component to collect charged droplets sprayed by the nozzle, that is, collects the charged droplets sprayed by the electrostatic atomization nozzle within a period of time (the spray time, generally ranging from dozens of seconds to several minutes) through the Faraday cylinder or grid, measures the total mass of the collected droplets by using a weighing instrument such as a balance, and meanwhile, measures the value of the current produced by the charged droplets flowing through the components such as the Faraday cylinder or grid by using an ammeter, and calculates the charge-to-mass ratio parameter of the nozzle through the value of the current I, the total mass of the droplets m, and the spray time t by using the formula (1):

$$\varepsilon = \frac{C}{m} = \frac{It}{m} \ (1)$$

wherein ε, in microcoulombs/kilogram, is the charge-to-mass ratio parameter of the electrostatic atomization nozzle; C, in microcoulombs, is the total quantity of electric charges of the charged droplets; I, in microcoulombs/second, is the value of the current produced by the charged droplets flowing through the droplet collection component and measured by the ammeter; m, in kilograms, is the total mass of the droplets sprayed by the electrostatic atomization nozzle; and t, in seconds, is the spray time of the electrostatic atomization nozzle.

The conventional measurement device has the following major problems.

1. Due to insulation and other requirements of an electrostatic spraying system, the conventional measurement device cannot directly measure the spray flow parameter of the electrostatic atomization nozzle through an instrument such as a flowmeter. It mainly adopts a weighing method to measure the total mass of the droplets sprayed by the nozzle during the spray time (ranging from dozens of seconds to several minutes), and uses the spray time to calculate the average charge-to-mass ratio parameter of the electrostatic atomization nozzle during this period of time, which leads to the problems such as long measurement time and slow system response in the conventional measurement method.

2. The conventional measurement method and device require a Faraday cylinder or grid to collect the charged droplets. In order to measure the total mass of the droplets, the charged droplets collected by the Faraday cylinder or grid need to be transferred or guided to a weighing vessel (such as a measuring cylinder). During the transfer of the charged droplets from the Faraday cylinder or grid to the vessel, due to adsorption, evaporation, leakage, and other factors of the liquid on the surface of the Faraday cylinder or grid and the like, loss of the charged droplets is caused during the process of flowing into the vessel, which increases the systematic error in the measurement of the total mass of the droplets, thereby increasing the measurement error of the charge-to-mass ratio parameter and also prolonging the measurement time.

3. The conventional method requires the spray time to calculate the value of the charge-to-mass ratio parameter. However, the existing measurement system still needs much improvement in the on/off control of the spraying system, the stability of the spraying parameter, the measurement of the spray time, and so on. Moreover, some of the spraying systems are manually operated, resulting in a certain error in the measurement of the spray time, which further increases the measurement error of the charge-to-mass ratio parameter.

4. In the conventional measurement device, the liquid flows or is stored in the components such as the electrostatic atomization nozzle, the Faraday cylinder (or grid), the water outlet pipeline, and the weighing vessel. The liquid needs to be handled manually during or after weighing. The components fail to form a closed liquid circulation system, and the liquid sprayed by the electrostatic atomization nozzle cannot be recycled. As for special test liquids or long-term tests, problems such as liquid leakage, contamination, or serious waste may easily occur.

The previous patent documents about devices and methods for measuring the charge-to-mass ratio parameter mainly focus on the conventional devices and methods for measuring the charge-to-mass ratio. The typical patent documents are summarized as follows.

The Chinese patent document with the application number of 201210457633.6 discloses a device for measuring the charge-to-mass ratio in electrostatic spraying. The device consists of a liquid collection cylinder, a measuring cylinder, a precision electronic balance, a picoammeter, and a data acquisition and processing system. The measurement device collects charged droplets through the liquid collection cylinder. The liquid collection cylinder consists of an outer liquid collection cylinder, an inner liquid collection cylinder, and an insulator between the inner and outer cylinders. The liquid inside the liquid collection cylinder is delivered to the measuring cylinder through a hose. The precision electronic balance is used for weighing the total mass of the droplets in the measuring cylinder. The picoammeter is used for current measurement. This measurement device is a conventional device for measuring the charge-to-mass ratio.

The Chinese patent document with the application number of 201310359398.3 discloses an easily disassembled and assembled device for real-time measurement of the charge-to-mass ratio of charged droplets. The device consists of a movable base, a bracket, a support plate, a hanger, an ammeter tray, a balance tray, and a Faraday cylinder. It also collects charged droplets by using the Faraday cylinder and measures the total mass of the droplets by using the balance. Compared with the conventional measurement device, this measurement device can be easily disassembled and moved by means of mechanisms such as the movable base designed in this patent. The content of this patent is an improved design of the conventional measurement device.

The Chinese patent document with the application number of 201310690188.2 discloses an device for measuring the charge-to-mass ratio in boom multi-nozzle electrostatic spraying. The device consists of an L-shaped bracket, a vertical moving platform, a horizontal sliding table, a Faraday cylinder, a precision balance, an ammeter, a lifting mechanism, and so on. It collects charged droplets by using the Faraday cylinder and measures the total mass of the droplets by using the precision balance. By adding horizontal movement and vertical lifting functions to the conventional measurement device, the measurement device of this invention is applicable to the measurement of the charge-to-mass ratio in boom multi-nozzle spraying. The content of this patent is also an improved design of the conventional measurement device.

The Chinese patent document with the application number of 201610007625.X discloses a device for measuring the charge-to-mass ratio of droplets in electrostatic spraying. The device mainly consists of a Faraday cylinder, a coulometer, a weight sensor, a water outlet pipeline, a liquid collection barrel, and a computer. It also collects charged droplets by using the Faraday cylinder, delivers the charged droplets in the Faraday cylinder to the liquid collection barrel through the water outlet pipeline, and measures the total mass of the droplets in the liquid collection barrel by using the weight sensor. This device is also a conventional device for measuring the charge-to-mass ratio.

The Chinese patent document with the application number of 201810322387.0 discloses a test stand for the charge-to-mass ratio of droplets in aviation plant protection electrostatic spraying. The test stand consists of a mesh charge-to-mass ratio collection box, a water collection tank, an electrostatic spraying system, a picoammeter, a computer, and so on. It mainly collects charged droplets by using the mesh charge-to-mass ratio collection box. The mesh charge-to-mass ratio collection box has multiple layers of copper meshes. The picoammeter is connected to the copper meshes to measure the current produced by the charged droplets flowing through the copper meshes. The water collection tank of the device gathers the collected droplets to facilitate weighing. The test stand is also a conventional device for measuring the charge-to-mass ratio.

## Summary

The charge-to-mass ratio parameter is a key indicator of the performance of an electrostatic atomization nozzle. The conventional device and method for measuring the charge-to-mass ratio have problems such as long measurement time, slow response, and poor accuracy. To improve the real-time performance and accuracy of the system for measuring the charge-to-mass ratio parameter of an electrostatic atomization nozzle, the present invention designs a system for measuring a charge-to-mass ratio of an electrostatic atomization nozzle and a measurement method using the same based on the principle of steady free outflow of a liquid flowing through an orifice of a vessel. The system and the method are capable of measuring in real time and monitoring the charge-to-mass ratio parameter of the electrostatic atomization nozzle, and feature high accuracy, rapid response, and the like.

The present invention has the following technical solutions:

## I. The structural solution of the measurement system

A system for measuring a charge-to-mass ratio of an electrostatic atomization nozzle includes an electrostatic atomization nozzle, an insulating bracket, an upper cylinder, a water retaining ring, a vortex breaker, a flow regulating plate, a lower cylinder, a lower-cylinder water outlet pipe, an ammeter, a metal conducting wire, a liquid level tube, an ultrasonic level meter, a water storage tank, a water supply pipe, a liquid pump, a branch pipeline, a pressure regulating valve, a throttle valve, a filter, a flowmeter, and a computer. The upper cylinder is formed by circumferentially connecting a gradually expanding upper-cylinder end cover and a thin-walled columnar upper-cylinder main body, the lower end of the upper cylinder is an opening, the upper end of the upper cylinder is the upper-cylinder end cover, and an end-cover central hole is provided at the center of the upper-cylinder end cover. The lower cylinder is formed by circumferentially welding a thin-walled columnar lower-cylinder main body and a gradually reducing lower-cylinder bottom cover, the upper end of the lower cylinder is an opening, and the lower end of the lower-cylinder bottom cover is connected to the lower-cylinder water outlet pipe. The upper cylinder and the lower cylinder are connected through an upper-cylinder flange and a lower-cylinder flange, thereby forming an internal cylindrical space with two open ends between the upper cylinder and the lower cylinder. The electrostatic atomization nozzle, the upper cylinder, and the lower cylinder are sequentially connected from top to bottom, and the electrostatic atomization nozzle is mounted in the middle of the end-cover central hole and sprays charged droplets vertically downward. The ammeter is connected to the lower-cylinder flange through the metal conducting wire, and is capable of measuring in real time the current produced by the charged droplets sprayed by the electrostatic atomization nozzle into the lower cylinder. The charged droplets sprayed by the electrostatic atomization nozzle are gathered in the lower cylinder, and under the influence of its own gravity, the liquid flows to the water storage tank through the lower-cylinder water outlet pipe, while the bottom end of the water storage tank is communicated with the water supply pipe and the liquid pump, enabling the liquid in the water storage tank to be delivered by the liquid pump to an inlet of the electrostatic atomization nozzle and again sprayed into the lower cylinder by the electrostatic atomization nozzle. The water supply pipe is communicated with the branch pipeline, and a part of the liquid delivered by the liquid pump flows back to the water storage tank through the branch pipeline. The liquid level tube is L-shaped and consists of a horizontal short tube and a vertical long tube which have thin-walled round tubular structures, the horizontal short tube is communicated with the lower cylinder, and the ultrasonic level meter is mounted on the upper end of the vertical long tube and is capable of measuring in real time the liquid level height in the liquid level tube and the lower cylinder. The ammeter, the ultrasonic level meter, and the flowmeter are connected to the computer through data cables, and the computer acquires and processes in real time measurement data of the ammeter, the ultrasonic level meter, and the flowmeter, thereby achieving real-time measurement and monitoring of the charge-to-mass ratio parameter of the electrostatic atomization nozzle.

The upper cylinder is fixed to a top fixing end through the insulating bracket, and the inner diameter of the upper-cylinder main body is equal to the inner diameter $D_1$ of the lower-cylinder main body. The wall of the upper cylinder is 8-12 millimeters thick. The water retaining ring is of a thin-walled columnar structure coaxial with the upper cylinder and is located in the upper cylinder, and the upper end surface of the water retaining ring is connected to the lower surface of the upper-cylinder end cover. The inner diameter of the water retaining ring is a half of the inner diameter $D_1$ of the lower-cylinder main body, and the water retaining ring is 2-4 millimeters thick. Several end-cover vent holes are provided on the edge of the upper-cylinder end cover, so that the internal cylindrical space formed between the upper cylinder and the lower cylinder is open to the atmosphere, and the end-cover vent holes are uniformly distributed along the circumference of the edge of the upper-cylinder end cover. The insulating bracket, the upper cylinder, and the water retaining ring are made of an insulating material, such as rubber, polyethylene, polypropylene, or polyvinyl chloride.

The vortex breaker and the flow regulating plate are disposed in the lower-cylinder main body, the vortex breaker is of a crossed structure formed by flat steel bars, and the flow regulating plate is of a circular steel plate structure provided with circular flow-through holes. The vortex breaker and the flow regulating plate are sequentially and horizontally arranged in the lower-cylinder main body from top to bottom, and the liquid gathered in the lower cylinder passes through the vortex breaker and the flow regulating plate in the process of flowing downward. The lower-cylinder flange is welded on the upper end surface of the lower-cylinder main body, the lower-cylinder flange and the upper-cylinder flange are matched and fixedly connected with each other, so that the upper cylinder and the lower cylinder are coaxially and fixedly connected, and a gasket is arranged between the lower-cylinder flange and the upper-cylinder flange to prevent leakage of the liquid. The lower cylinder and the lower-cylinder water outlet pipe are made of a metal material such as carbon steel, stainless steel, and aluminum alloys, and the outer surfaces thereof are treated with polymer spraying to improve insulation performance from outside. The walls of the lower cylinder and the lower-cylinder water outlet pipe are 5-8 millimeters thick.

The upper-cylinder main body and the lower-cylinder main body are of thin-walled columnar structures, and the lower-cylinder water outlet pipe is of a columnar short pipe structure, wherein the inner diameter $D_1$ of the lower-cylinder main body ranges from 0.3-0.6 meters, the inner diameter $d_1$ of the lower-cylinder water outlet pipe ranges from 0.001 meter-0.005 meters, and the length $L_1$ of the lower-cylinder water outlet pipe ranges from $4d_1$-$5d_1$, the lower-cylinder main body, the lower-cylinder bottom cover, and the lower-cylinder water outlet pipe are sequentially connected from top to bottom, and the height H of the lower cylinder is designed by using the following formula:

$$H = k_1 \frac{q^2}{gd_1^4}$$

wherein H, in meters, is the height of the lower cylinder;

q, in cubic meters/second, is designed spray flow of the measurement system;
g, in meters/second squared, is gravitational acceleration;
$d_1$, in meters, is the inner diameter of the lower-cylinder water outlet pipe;
$k_1$ is modification coefficient, $k_1$=1.6-2.4.

The flow regulating plate of a circular steel plate structure is horizontally arranged in the lower-cylinder main body, a certain number of the circular flow-through holes are provided on the surface of the flow regulating plate, and the diameter $d_2$ of the circular flow-through hole, the number N of the circular flow-through holes, and the inner diameter $D_1$ of the lower-cylinder main body satisfy the following relationship:

$$0.4 \ll \frac{Nd_2^2}{D_1^2} \ll 0.6$$

wherein $d_2$, in meters, is the diameter of the circular flow-through hole;

N is the number of the circular flow-through holes;
$D_1$, in meters, is the inner diameter of the lower-cylinder main body.

The liquid level tube is located on the side surface of the lower cylinder and consists of the horizontal short tube and the vertical long tube welded together, the horizontal short tube is horizontally arranged, and the vertical long tube is vertically arranged. A liquid level tube vent hole is provided on the upper end of the vertical long tube, so that the liquid level tube is open to the atmosphere, and meanwhile, the horizontal short tube is communicated with the lower cylinder, thereby forming mutual communication between the liquid level tube, the lower cylinder, and the atmosphere, wherein the center of the liquid level tube vent hole is higher than the end surface of the lower-cylinder flange. The ultrasonic level meter is mounted on the upper end of the vertical long tube, the probe of the ultrasonic level meter faces vertically downward, and the ultrasonic level meter is capable of measuring in real time the liquid level height in the liquid level tube and the lower cylinder. The liquid level tube is made of a metal material such as carbon steel, stainless steel, and aluminum alloys, and the outer surface thereof is treated with polymer spraying. The wall of the liquid level tube is 4-6 millimeters thick and is not thicker than that of the lower cylinder. The ammeter is a microammeter or picoammeter, the input end of the ammeter is connected to the outer surface of the lower-cylinder flange through the metal conducting wire, and the output end of the ammeter is connected to a ground terminal.

The water storage tank is a cylindrical vessel having a closed bottom end and an opening upper end and is located below the lower-cylinder water outlet pipe, the water storage tank is communicated with the inlet of the electrostatic atomization nozzle through the water supply pipe, the liquid pump, the throttle valve, the filter, and the flowmeter, and the flowmeter is located near the inlet of the electrostatic atomization nozzle and acquires in real time the spray flow of the electrostatic atomization nozzle. The water supply pipe is arranged between the liquid pump and the throttle valve and is connected to the branch pipeline. The pressure regulating valve is disposed on the branch pipeline and is capable of being controlled to adjust the output pressure of the liquid pump and the spray pressure of the electrostatic atomization nozzle. An outlet of the branch pipeline faces the opening upper end of the water storage tank, enabling a part of the liquid to flow back to the water storage tank through the branch pipeline and the pressure regulating valve. The water storage tank is made of a metal material such as carbon steel, stainless steel, and aluminum alloys, and the water supply pipe and the branch pipeline are made of an insulating material, such as rubber, polyethylene, polypropylene, or polyvinyl chloride.

**II. The working principle of the system for measuring the charge-to-mass ratio**

**1. The working mode of the system for measuring the charge-to-mass ratio**

According to different working states of the electrostatic atomization nozzle and the measurement system, the measurement system has the following two working modes:
The first working mode is used for measuring the charge-to-mass ratio parameter of the electrostatic atomization nozzle of an electrostatic sprayer in a working state, and in this case, the electrostatic sprayer is directly connected to the electrostatic atomization nozzle, the electrostatic atomization nozzle is a part of the electrostatic sprayer, and during the spray test, the electrostatic sprayer provides the electrostatic atomization nozzle with the liquid to be sprayed. When the charge-to-mass ratio parameter of the electrostatic atomization nozzle is measured in the first working mode, the liquid pump, the pressure regulating valve, and the throttle valve are in a closed state.

In the second working mode, the electrostatic atomization nozzle functions as an independent component to be measured and is not connected to the external electrostatic sprayer, the liquid is driven by the liquid pump to flow in closed circulation in the components such as the electrostatic atomization nozzle, the lower cylinder, the lower-cylinder water outlet pipe, the water storage tank, and the water supply pipe, so that the electrostatic atomization nozzle is continuously supplied with the liquid to be sprayed and the proceeding of the spray test is ensured, and meanwhile, the pressure regulating valve is controlled to adjust the output pressure of the liquid pump and the spray pressure of the electrostatic atomization nozzle, to realize measurement of the charge-to-mass ratio parameter under different spray pressures. When the charge-to-mass ratio parameter of the electrostatic atomization nozzle is measured in the second working mode, the liquid pump, the pressure regulating valve, and the throttle valve are in an open state.

**2. The working principle of the system for measuring the charge-to-mass ratio**

When the electrostatic atomization nozzle is in the first working mode or the second working mode, the charged droplets sprayed downward by the electrostatic atomization nozzle are gathered in the lower cylinder, and under the influence of its own gravity, the liquid gathered in the lower cylinder flows to the water storage tank through the lower-cylinder water outlet pipe, and the charges carried by the charged droplets flow to the ground through the lower cylinder, the metal conducting wire, and the ammeter; therefore, the current produced by the charged droplets sprayed by the electrostatic atomization nozzle into the lower cylinder can be measured in real time by the ammeter. During the initial spray stage, the liquid level in the lower cylinder is low, and the liquid flow from the lower-cylinder water outlet pipe to the water storage tank is smaller than the spray flow of the electrostatic atomization nozzle. With the ongoing of the spray test, the liquid level in the lower cylinder gradually increases, and according to the principle of steady free outflow of a liquid flowing through an orifice of a vessel, the liquid flow from the lower-cylinder water outlet pipe to the water storage tank increases accordingly. When the liquid level in the lower cylinder reaches a certain value, the liquid flow from the lower-cylinder water outlet pipe to the water storage tank is equal to the spray flow of the electrostatic atomization nozzle. In this case, the flow in the lower cylinder is in a steady state, and the liquid level in the lower cylinder and the current value of the ammeter are also in a steady state. According to the principle of steady free outflow of a liquid flowing through an orifice of a vessel, the spray flow Q can be calculated by using the following formula (2):

$$Q = k_0 d_1^2 \sqrt{gh} \quad (2)$$

wherein Q, in cubic meters/second, is the spray flow of the electrostatic atomization nozzle; $k_0$ is a flow factor and is a dimensionless number; $d_1$, in meters, is the inner diameter of the lower-cylinder water outlet pipe; g, in meters/second squared, is gravitational acceleration; h, in meters, is the liquid level height in the lower cylinder.

Based on the definition of the charge-to-mass ratio parameter of the electrostatic atomization nozzle, through the formula (2) of calculating the spray flow, the present invention calculates the charge-to-mass ratio parameter by using the formula (3):

$$\varepsilon = \frac{C}{m} = 1000 \frac{I}{\rho Q} = k_1 \frac{I}{\rho d_1^2 \sqrt{gh}} \quad (3)$$

wherein $\varepsilon$, in microcoulombs/kilogram, is the charge-to-mass ratio parameter of the electrostatic atomization nozzle; C, in microcoulombs, is the total quantity of electric charges of the charged droplets; I, in amperes, is the value of the current produced by the charged droplets flowing through the droplet collection component and measured by the ammeter; m, in kilograms, is the total mass of the droplets sprayed by the electrostatic atomization nozzle; Q, in cubic meters/second, is the spray flow of the electrostatic atomization nozzle; $\rho$, in kilograms/cubic meter, is the density of the liquid to be sprayed by the electrostatic atomization nozzle; $k_1$ is modification coefficient, $k_1 = \frac{1000}{k_0}$ , $k_0$ is a flow factor and is a dimensionless number; $d_1$, in meters, is the inner diameter of the lower-cylinder water outlet pipe; g, in meters/second squared, is gravitational acceleration; h, in meters, is the liquid level height in the lower cylinder.

It can be seen from the above that, the liquid level height in the lower cylinder can be measured by using the ultrasonic level meter, and based on the principle of steady free outflow of a liquid flowing through an orifice of a vessel, the spray flow can be calculated indirectly. Meanwhile, the value of the current produced by the charged droplets sprayed by the electrostatic atomization nozzle into the lower cylinder is measured by the ammeter. Based on this, the charge-to-mass ratio parameter of the electrostatic atomization nozzle can be acquired through the spray flow and the current value, thereby achieving real-time measurement and monitoring of the charge-to-mass ratio parameter of the electrostatic atomization nozzle.

### III. The measurement method of the system for measuring the charge-to-mass ratio

### 1. The methods for acquiring measurement data

According to the working modes of the measurement system, two methods for acquiring measurement data are provided as follows:

(1) The method for acquiring measurement data in the first working mode
When the measurement system is in the first working mode, the computer acquires in real time the measurement data of the ammeter and the ultrasonic level meter, and the specific measurement method includes the following steps:

during the spray test of the electrostatic atomization nozzle, acquiring, by the computer, in real time data of the current I output by the ammeter according to a sampling period $T_1$ of the ammeter, and acquiring in real time data of the liquid level height h output by the ultrasonic level meter according to a sampling period $T_2$ of the ultrasonic level meter, the sampling duration of the computer being t1 ranging from 30T-50T, wherein T is a larger value of $T_1$ and $T_2$;
during the system test, acquiring, by the computer, the data of the current I and the liquid level height h within the sampling duration t1 to respectively generate arrays $I1=[I1_1, I1_2, ..., I1_n]$ and $h1=[h1_1, h1_2, ..., h1_n]$; firstly calculating, by the computer, coefficients of fluctuation $S1_{h1} = \frac{\max(h1)-\min(h1)}{\overline{h1}}$ and $S2_{h1} = \left|\frac{h1_m}{\overline{h1}}\right|$ of the array h1, wherein max(h1) is the maximum value in the array h1, min(h1) is the minimum value in the array h1, $\overline{h1} = \frac{\sum_{i=1}^{n} h1_i}{n}$ , and $h1_m$ is the median of the array h1;
when the coefficients of fluctuation $S1_{h1}$ and $S2_{h1}$ satisfy both the conditions $S1_{h1} \leq 6\%$ and $97\% \leq S2_{h1} \leq 103\%$, processing, by the computer, the arrays I1 and h1, respectively acquiring through calculation the mean values $\overline{I1} = \frac{\sum_{i=1}^{n} I1_i}{n}$ and $\overline{h1} = \frac{\sum_{i=1}^{n} h1_i}{n}$ of the arrays I1 and h1, and outputting $\overline{I1}$ and $\overline{h1}$ as the real-time current value and the real-time liquid level height of this spray test respectively;
when the coefficients of fluctuation $S1_{h1}$ and $S2_{h1}$ fail to satisfy both the conditions $S1_{h1} \leq 6\%$ and $97\% < S2_{h1} < 103\%$, still outputting, by the computer, $\overline{I1}$ and $\overline{h1}$ as the real-time current value and the real-time liquid level height of this spray test respectively, and meanwhile, outputting the coefficients of fluctuation $S1_{h1}$ and $S2_{h1}$ synchronously for the reference of testers.

(2) The method for acquiring measurement data in the second working mode
When the measurement system is in the second working mode, the computer acquires in real time the measurement data of the ammeter, the ultrasonic level meter, and the flowmeter, and the specific measurement method includes the following steps:

during the spray test of the electrostatic atomization nozzle, acquiring, by the computer, in real time data of the current I output by the ammeter according to the sampling period $T_1$ of the ammeter, acquiring in real time data of the liquid level height h output by the ultrasonic level meter according to the sampling period $T_2$ of the ultrasonic level meter, and acquiring in real time data of the spray flow q output by the flowmeter according to a sampling period $T_3$ of the flowmeter, the sampling duration of the computer being t2 ranging from 30T-50T, wherein T is the maximum value of $T_1$, $T_2$, and $T_3$;

during the system test, acquiring, by the computer, the data of the current I, the liquid level height h, and the spray flow q within the sampling duration t2 to respectively generate arrays $I2=[I2_1, I2_2, ..., I2_n]$, $h2=[h2_1, h2_2, ..., h2_n]$, and $q1=[q1_1, q1_2, ..., q1_n]$, firstly calculating, by the computer, coefficients of fluctuation

$$S1_{h2} = \frac{\max(h2)-\min(h2)}{\overline{h2}}, \ S2_{h2} = \left|\frac{h2_m}{\overline{h2}}\right|, \ S1_{q1} = \frac{\max(q1)-\min(q1)}{\overline{q1}}, \text{ and } S2_{q1} = \left|\frac{q1_m}{\overline{q1}}\right|$$

of the arrays h2 and q1, wherein max(h2) is the maximum value in the array h2, min(h2) is the minimum value in the array h2,

$$\overline{h2} = \frac{\sum_{i=1}^{n} h2_i}{n}$$

and $h2_m$ is the median of the array h2, max(q1) is the maximum value in the array q1, min(q1)

$$\overline{q1} = \frac{\sum_{i=1}^{n} q1_i}{n}$$

is the minimum value in the array q1, and $q1_m$ is the median of the array q1;

when the coefficients of fluctuation $S1_{h2}$, $S2_{h2}$, $S1_{q1}$, and $S2_{q1}$ satisfy all the conditions $S1_{h2} \leq 6\%$, $97\% \leq S2_{h2} \leq 103\%$, $S1_{q1} \leq 3\%$, and $98\% \leq S2_{q1} \leq 102\%$, processing, by the computer, the arrays I2 and h2, re-

spectively acquiring through calculation the mean values $\overline{I2} = \frac{\sum_{i=1}^{n} I2_i}{n}$ and $\overline{h2} = \frac{\sum_{i=1}^{n} h2_i}{n}$ of the arrays I2 and h2, and outputting $\overline{I2}$ and $\overline{h2}$ as the real-time current value and the real-time liquid level height of this spray test respectively;

when the coefficients of fluctuation $S1_{h2}$, $S2_{h2}$, $S1_{q1}$, and $S2_{q1}$ fail to satisfy all the conditions $S1_{h2} \leq 6\%$, $97\% \leq S2_{h2} \leq 103\%$, $S1_{q1} \leq 3\%$, and $98\% \leq S2_{q1} \leq 102\%$, still outputting, by the computer, $\overline{I2}$ and $\overline{h2}$ as the real-time current value and the real-time liquid level height of this spray test respectively, and meanwhile, outputting the coefficients of fluctuation $S1_{h2}$, $S2_{h2}$, $S1_{q1}$, and $S2_{q1}$ synchronously for the reference of testers.

## 2. The method for measuring and calculating the charge-to-mass ratio parameter

When the measurement system is in the first working mode or the second working mode, the computer system calculates the charge-to-mass ratio parameter of the electrostatic atomization nozzle according to the real-time current value and the real-time liquid level height output in the spray test, and it can be seen from the calculation formula (3) that, the charge-to-mass ratio parameter is specifically calculated by using the following formula:

$$\varepsilon = k_1 \frac{\overline{I1}}{\rho d_1^2 \sqrt{g\overline{h1}}} = k_1 \frac{\overline{I2}}{\rho d_1^2 \sqrt{g\overline{h2}}}$$

wherein $\varepsilon$, in microcoulombs/kilogram, is the charge-to-mass ratio parameter of the electrostatic atomization nozzle;

$\rho$, in kilograms/cubic meter, is the density of the liquid to be sprayed by the electrostatic atomization nozzle;
$d_1$, in meters, is the inner diameter of the lower-cylinder water outlet pipe;
g, in meters/second squared, is gravitational acceleration;
$k_1$ is modification coefficient, $k_1 = 1080-1120$;
$\overline{I1}$ and $\overline{I2}$, in amperes, are real-time current values during the test of the measurement system;
$\overline{h1}$ and $\overline{h2}$, in meters, are real-time liquid level heights during the test of the measurement system.

Compared with the conventional device and method for measuring the charge-to-mass ratio parameter in the prior art, the system for measuring the charge-to-mass ratio of an electrostatic atomization nozzle and the measurement method using the same provided by the present invention have the following features:

(1) Based on the principle of steady free outflow of a liquid flowing through an orifice of a vessel, the present invention designs the measurement system capable of acquiring in real time the spray flow of an electrostatic atomization nozzle. The system adopts the upper cylinder and the lower cylinder as droplet collection components, and by means of the components such as the lower cylinder, the liquid level tube, and the ultrasonic level meter, measures in real time the liquid level height in the lower cylinder to indirectly measure the spray flow of the electrostatic atomization nozzle, thereby realizing external real-time measurement of the spray flow of the electrostatic atomization nozzle, so that the spray flow does not need to be measured by mounting a flowmeter in the electrostatic sprayer or the like.

(2) The measurement system provided by the present invention adopts the upper cylinder and the lower cylinder as droplet collection components, and realizes real-time measurement of the spray flow directly through the components such as the liquid level tube and the ultrasonic level meter on the side surface of the lower cylinder. The charged droplets do not need to be transferred or guided to other vessels for weighing during the test. Therefore, the test process is simpler, and the measurement errors caused by factors such as adsorption, evaporation, and leakage during the transfer or guidance of the charged droplets are eliminated.

(3) By using the value of the current I and the spray flow Q, the measurement system provided by the present invention can directly acquire through calculation the charge-to-mass ratio parameter of the electrostatic atomization nozzle. Since the sampling duration of the measurement system (several milliseconds to dozens of milliseconds) is very short, the measurement system has good real-time performance. Meanwhile, the method for measuring the charge-to-mass ratio based on the calculation formula (3) eliminates the spray time in the conventional measurement method, thereby reducing sources of errors and simplifying the test process.

(4) In the measurement system provided by the present invention, the electrostatic atomization nozzle, the lower cylinder, the lower-cylinder water outlet pipe, the water storage tank, the water supply pipe, the liquid pump, the pressure regulating valve, and other components form a closed liquid circulation system, realizing closed circulation of the liquid in the measurement system. When the electrostatic atomization nozzle functions as an independent component to be measured and is not connected to the external electrostatic sprayer, the measurement system can provide a liquid having a certain spray pressure for continuous spray of the electrostatic atomization nozzle, the liquid can be recycled in the measurement system, the problems such as liquid leakage and contamination may not be easily caused, and advantages such as adjustable spray pressure are also achieved.

## Brief Description of the Drawings

The present invention is further described below with reference to the accompanying drawings and specific embodiments.

FIG. 1 is a schematic structural view of an overall solution according to an embodiment of the present invention;
FIG. 2 is a partial cross-sectional view of the same embodiment, which includes components such as an upper cylinder, a lower cylinder, and a liquid level tube;
FIG. 3 is a radial cross-sectional view of a vortex breaker in the same embodiment; and
FIG. 4 is a radial cross-sectional view of a flow regulating plate in the same embodiment.

In the drawings, 1. electrostatic atomization nozzle, 2. insulating bracket, 3. upper cylinder, 4. water retaining ring, 5. vortex breaker, 6. flow regulating plate, 7. lower cylinder, 8. lower-cylinder water outlet pipe, 9. ammeter, 10. metal conducting wire, 11. liquid level tube, 12. ultrasonic level meter, 13. water storage tank, 14. water supply pipe, 15. liquid pump, 16. branch pipeline, 17. pressure regulating valve, 18. throttle valve, 19. filter, 20. flowmeter, 21. water supply pipe of an electrostatic sprayer, 22. end-cover central hole, 23. upper-cylinder end cover, 24. end-cover vent hole, 25. upper-cylinder main body, 26. upper-cylinder flange, 27. lower-cylinder flange, 28. lower-cylinder main body, 29. lower-cylinder bottom cover, 30. inner diameter $D_1$ of the lower-cylinder main body, 31. height H of the lower cylinder, 32. inner diameter $d_1$ of the lower-cylinder water outlet pipe, 33. length $L_1$ of the lower-cylinder water outlet pipe, 34. horizontal short tube, 35. vertical long tube, 36. liquid level tube vent hole, 37. circular flow-through hole, 38. diameter $d_2$ of the circular flow-through hole.

## Detailed Description of the Embodiments

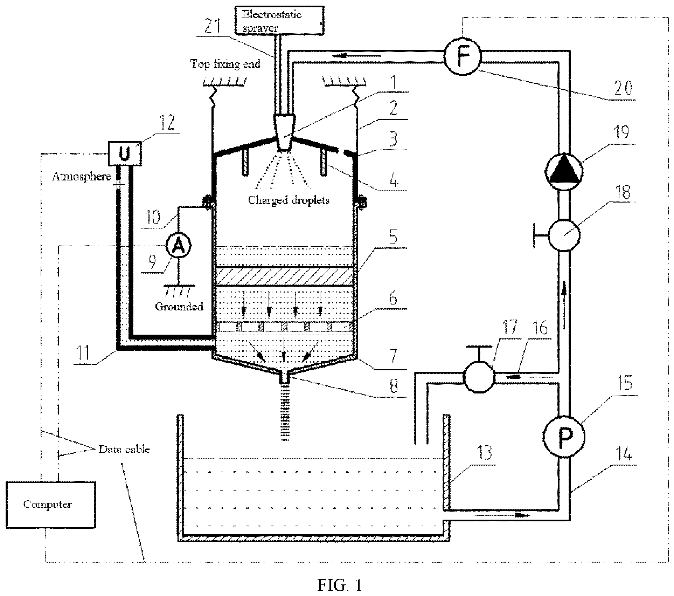

FIG. 1 to FIG. 4 show the structure of an embodiment of the measurement system. In this embodiment, the spray flow is designed to be q=1.2 liters/minute=$2\times10^{-5}$ cubic meters/second. The system for measuring the charge-to-mass ratio of an electrostatic atomization nozzle and the measurement method using the same provided by the present invention are described clearly and completely below with reference to the accompanying drawings of the embodiment of the present invention.

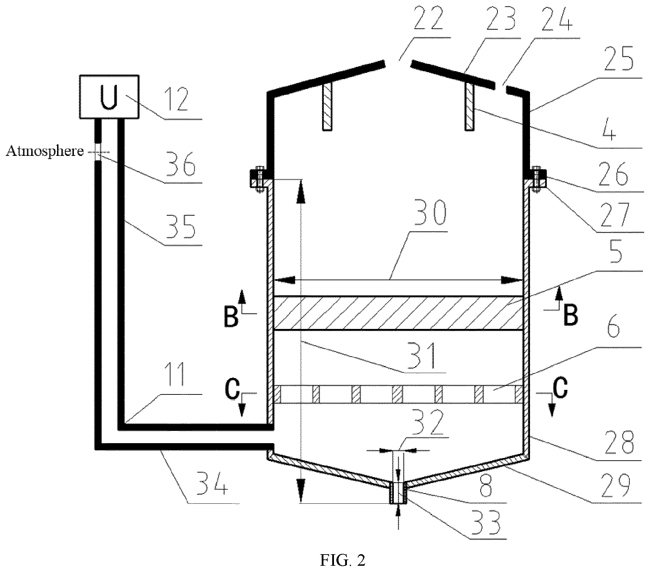

FIG. 1 and FIG. 2 are schematic views of the system for measuring the charge-to-mass ratio of an electrostatic atomization nozzle provided by the embodiment of the present invention. The measurement system consists of an electrostatic atomization nozzle 1, an insulating bracket 2, an upper cylinder 3, a water retaining ring 4, a vortex breaker 5, a flow regulating plate 6, a lower cylinder 7, a lower-cylinder water outlet pipe 8, an ammeter 9, a metal conducting wire 10, a liquid level tube 11, an ultrasonic level meter 12, a water storage tank 13, a water supply pipe 14, a liquid pump 15, a branch pipeline 16, a pressure regulating valve 17, a throttle valve 18, a filter 19, a flowmeter 20, and a computer. The upper cylinder 3 consists of a gradually expanding upper-cylinder end cover 23 and a thin-walled columnar upper-cylinder main body 25. The lower end of the upper cylinder 3 is an opening, and the upper end of the upper cylinder 3 is the upper-cylinder end cover 23. An end-cover central hole 22 is provided at the center of the upper-cylinder end cover 23. The lower cylinder 7 is formed by circumferentially welding a thin-walled columnar lower-cylinder main body 28 and a gradually reducing lower-cylinder bottom cover 29. The upper end of the lower cylinder 7 is an opening. The lower end of the lower-cylinder bottom cover 29 is connected to the lower-cylinder water outlet pipe 8. The upper cylinder 3 and the lower cylinder 7 are vertically connected through an upper-cylinder flange 26 and a lower-cylinder flange 27, thereby forming an internal cylindrical space with two open ends between the upper cylinder 3 and the lower cylinder 7. The electrostatic atomization nozzle 1, the upper cylinder 3, and the lower cylinder 7 are vertically and sequentially connected from top to bottom. The electrostatic atomization nozzle 1 is mounted in the middle of the end-cover central hole 22, and sprays charged droplets vertically downward. The ammeter 9 is connected to the lower-cylinder flange 27 through the metal conducting wire 10. The charged droplets sprayed by the electrostatic atomization nozzle 1 are gathered in the lower cylinder 7. Under the influence of its own gravity, the liquid flows to the water storage tank 13 through the lower-cylinder water outlet pipe 8. The bottom end of the water storage tank 13 is communicated with the water supply pipe 14 and the liquid pump 15, enabling the liquid in the water storage tank 13 to be delivered by the liquid pump 15 to an inlet of the electrostatic atomization nozzle 1 and again sprayed into the lower cylinder 7 by the electrostatic atomization nozzle 1. The water supply pipe 14 is communicated with the branch pipeline 16. A part of the liquid delivered by the liquid pump 15 flows back to the water storage tank 13 through the branch pipeline 16. The liquid level tube 11 is L-shaped and consists of a horizontal short tube 34 and a vertical long tube 35 which have thin-walled round tubular structures. The horizontal short tube 34 is communicated with the lower cylinder 7. The ultrasonic level meter 12 is mounted on the upper end of the vertical long tube 35 and is capable of measuring in real time the liquid level height in the liquid level tube 11 and the lower cylinder 7. The ammeter 9, the ultrasonic level meter 12, and the flowmeter 20 are connected to the computer through data cables. The computer acquires and processes in real time measurement data of the ammeter 9, the ultrasonic level meter 12, and the flowmeter 20, thereby achieving real-time measurement and monitoring of the charge-to-mass ratio parameter of the electrostatic atomization nozzle 1.

As shown in FIG. 1, the insulating bracket 2 is fixedly connected between the upper-cylinder end cover 23 and a top fixing end, and thus the upper cylinder 3 is fixed to the top fixing end through the insulating bracket 2. The inner diameter of the upper-cylinder main body 25 is equal to the inner diameter $D_1$ of the lower-cylinder main body. The inner diameter of the upper-cylinder main body 25 is 0.4 meters, and the wall of the upper cylinder 3 is 8 millimeters thick. The water retaining ring 4 is of a thin-walled columnar structure coaxial with the upper cylinder 3, and is located in the upper cylinder 3. The upper end surface of the water retaining ring 4 is connected to the lower surface of the upper-cylinder end cover 23. The inner diameter of the water retaining ring 4 is 0.2 meters, ensuring that the charged droplets sprayed by the electrostatic atomization nozzle 1 may not directly hit the inner surface of the water retaining ring 4. The water retaining ring 4 is 2 millimeters thick. Several end-cover vent holes 24 are provided on the edge of the upper-cylinder end cover 23, so that the internal cylindrical space formed between the upper cylinder 3 and the lower cylinder 7 is open to the atmosphere. The end-cover vent holes 24 are uniformly distributed along the circumference of the edge of the upper-cylinder end cover 23. The inner diameter of the end-cover vent hole 24 is 10 millimeters, and the number of the end-cover vent holes 24 is 12. The insulating bracket 2, the upper cylinder 3, and the water retaining ring 4 are made of an insulating material, such as rubber, polyethylene, polypropylene, or polyvinyl chloride.

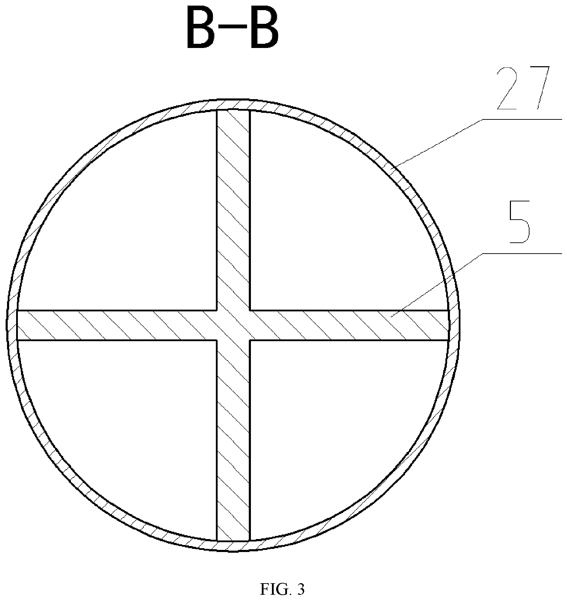

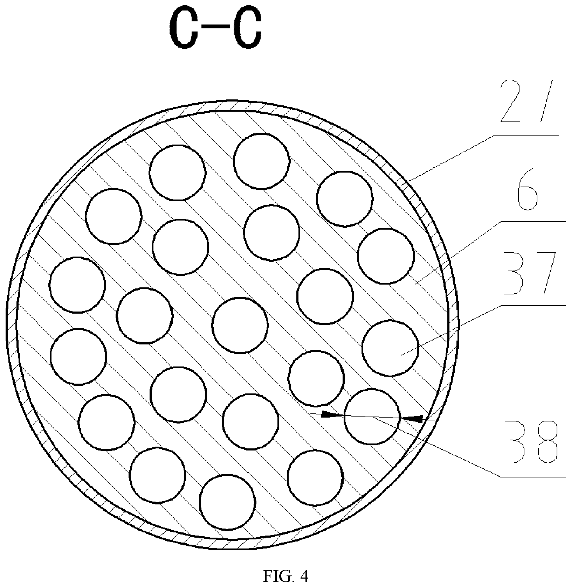

As shown in FIG. 2, the vortex breaker 5 and the flow regulating plate 6 are disposed in the lower-cylinder main body 28. As shown in FIG. 3, the vortex breaker 5 is of a crossed structure formed by flat steel bars. As shown in FIG. 4, the flow regulating plate 6 is of a circular steel plate structure provided with circular flow-through holes 37. As shown in FIG. 2, the vortex breaker 5 and the flow regulating plate 6 are sequentially and horizontally arranged in the lower-cylinder main body 28 from top to bottom. The liquid gathered in the lower cylinder 7 passes through the vortex breaker 5 and the flow regulating plate 6 in the process of flowing downward. The lower-cylinder flange 27 is welded on the upper end surface of the lower-cylinder main body 28. The lower-cylinder flange 27 and the upper-cylinder flange 26 are matched and fixedly connected with each other, so that the upper cylinder 3 and the lower cylinder 7 are fixedly connected. A gasket is arranged between the lower-cylinder flange 27 and the upper-cylinder flange 26 to prevent leakage of the liquid. The lower cylinder 7 and the lower-cylinder water outlet pipe 8 are made of a metal material such as carbon steel, stainless steel, and aluminum alloys, and the outer surfaces thereof are treated with polymer spraying to improve insulation performance from outside. The walls of the vortex breaker 5, the flow regulating plate 6, the lower cylinder 7, and the lower-cylinder water outlet pipe 8 are all 6 millimeters thick.

As shown in FIG. 2, the upper-cylinder main body 25 and the lower-cylinder main body 28 are of thin-walled columnar structures. The inner diameter $D_1$ of the lower-cylinder main body is 0.4 meters. The lower-cylinder water outlet pipe 8 is of a columnar short pipe structure, the inner diameter $d_1$ of the lower-cylinder water outlet pipe is 0.0035 meters, and the length $L_1$ of the lower-cylinder water outlet pipe is 0.015 meters. The height H of the lower cylinder is designed by using the following formula:

$$H = k_1 \frac{q^2}{gd_1^4}$$

wherein H, in meters, is the height of the lower cylinder; q, in cubic meters/second, is designed spray flow of the measurement system; g, in meters/second squared, is gravitational acceleration and the value thereof in this embodiment is 9.81 meters/second squared; $d_1$, in meters, is the inner diameter of the lower-cylinder water outlet pipe; $k_1$ is modification coefficient, $k_1$=1.6-2.4. According to the above design formula, the height H of the lower cylinder in this embodiment ranges from 0.44-0.65 meters, and the height H of the lower cylinder is finally determined to be 0.5 meters.

As shown in FIG. 4, the flow regulating plate 6 of a circular steel plate structure is horizontally arranged in the lower-cylinder main body 28. A certain number of the circular flow-through holes 37 are provided on the surface of the flow regulating plate 6 and are distributed at equal intervals. The diameter $d_2$ of the circular flow-through hole, the number N of the circular flow-through holes, and the inner diameter $D_1$ of the lower-cylinder main body satisfy the following relationship:

$$0.4 \ll \frac{Nd_2^2}{D_1^2} \ll 0.6$$

wherein $d_2$, in meters, is the diameter of the circular flow-through hole; N is the number of the circular flow-through holes; and $D_1$, in meters, is the inner diameter of the lower-cylinder main body. In this embodiment, the inner diameter $D_1$ of the lower-cylinder main body is 0.4 meters, the diameter $d_2$ of the circular flow-through hole is 60 millimeters, and the number N of the circular flow-through holes is 21, which meet the above design requirement.

As shown in FIG. 2, the liquid level tube 11 is located on the side surface of the lower cylinder 7, and consists of the horizontal short tube 34 and the vertical long tube 35 welded together. The horizontal short tube 34 is horizontally arranged, and the vertical long tube 35 is vertically arranged. The inner diameters of the horizontal short tube 34 and the vertical long tube 35 are 0.1 meter, and the walls thereof are 6 millimeters thick. A liquid level tube vent hole 36 is provided on the upper end of the vertical long tube 35, so that the liquid level tube 11 is open to the atmosphere, and meanwhile, the horizontal short tube 34 is communicated with the lower cylinder 7, thereby forming mutual communication between the liquid level tube 11, the lower cylinder 7, and the atmosphere. The center of the liquid level tube vent hole 36 is higher than the end surface of the lower-cylinder flange 27. The diameter of the liquid level tube vent hole 36 is 50 millimeters. The ultrasonic level meter 12 is mounted on the upper end of the vertical long tube 35, and the probe of the ultrasonic level meter 12 faces vertically downward. The ultrasonic level meter 12 is capable of measuring in real time the liquid level height in the liquid level tube 11 and the lower cylinder 7. The liquid level tube 11 is made of a metal material such as carbon steel, stainless steel, and aluminum alloys, and the outer surface thereof is treated with polymer spraying. The ammeter 9 is a microammeter or picoammeter. The input end of the ammeter 9 is connected to the outer surface of the lower-cylinder flange 27 through the metal conducting wire 10, and the output end of the ammeter 9 is connected to a ground terminal.

As shown in FIG. 2, the water storage tank 13 is a cylindrical vessel having a closed bottom end and an opening upper end, and is located below the lower-cylinder water outlet pipe 8. The water storage tank 13 is communicated with the inlet of the electrostatic atomization nozzle 1 through the water supply pipe 14, the liquid pump 15, the throttle valve 18, the filter 19, and the flowmeter 20. The flowmeter 20 is located near the inlet of the electrostatic atomization nozzle 1, and acquires in real time the spray flow of the electrostatic atomization nozzle 1. The liquid in the water storage tank 13 is driven by the liquid pump 15 to flow through the water supply pipe 14, the throttle valve 18, the filter 19, the flowmeter 20, and the electrostatic atomization nozzle 1, is then sprayed by the electrostatic atomization nozzle 1 into the lower cylinder 7, and again flows to the water storage tank 13 through the lower-cylinder water outlet pipe 8; therefore, the liquid flows in closed circulation in the measurement system. The water supply pipe 14 is arranged between the liquid pump 15 and the throttle valve 18 and is connected to the branch pipeline 16. The pressure regulating valve 17 is disposed on the branch pipeline 16 and is capable of being controlled to adjust the output pressure of the liquid pump 15 and the spray pressure of the electrostatic atomization nozzle 1. An outlet of the branch pipeline 16 is located above the water storage tank 13, and faces the opening upper end of the water storage tank 13, enabling a part of the liquid to flow back to the water storage tank 13 through the branch pipeline 16 and the pressure regulating valve 17. The water storage tank 13 is made of a metal material such as carbon steel, stainless steel, and aluminum alloys. The water supply pipe 14 and the branch pipeline 16 are made of an insulating material, such as rubber, polyethylene, polypropylene, or polyvinyl chloride.

As shown in FIG. 1, the measurement system has two working modes.

The first working mode is used for measuring the charge-to-mass ratio parameter of the electrostatic atomization nozzle 1 of an electrostatic sprayer in a working state. In this case, the electrostatic atomization nozzle 1 is directly connected to the electrostatic sprayer, and the external electrostatic sprayer provides the electrostatic atomization nozzle 1 with the liquid to be sprayed. The electrostatic atomization nozzle 1 is a part of the electrostatic sprayer. When the charge-to-mass ratio parameter of the electrostatic atomization nozzle 1 is measured in the first working mode, the liquid pump 15, the pressure regulating valve 17, and the throttle valve 18 are in a closed state, the computer only acquires measurement data of the ammeter 9 and the ultrasonic level meter 12, and the liquid does not flow in closed circulation in the measurement system.

In the second working mode, the electrostatic atomization nozzle 1 functions as an independent component to be measured, and is not connected to the external electrostatic sprayer. Driven by the liquid pump 15, the liquid flows in closed circulation in the components such as the electrostatic atomization nozzle 1, the lower cylinder 7, the lower-cylinder water outlet pipe 8, the water storage tank 13, and the water supply pipe 14, so that the electrostatic atomization nozzle 1 is continuously supplied with the liquid to be sprayed and the proceeding of the spray test is ensured. When the charge-to-mass ratio parameter of the electrostatic atomization nozzle 1 is measured in the second working mode, the liquid pump 15, the pressure regulating valve 17, and the throttle valve 18 are in an open state, and the computer acquires measurement data of the ammeter 9, the ultrasonic level meter 12, and the flowmeter 20 at the same time.

When the measurement system is in the first working mode, the computer acquires in real time the measurement data of the ammeter and the ultrasonic level meter. The specific measurement method includes the following steps.

During the spray test of the electrostatic atomization nozzle 1, the computer acquires in real time data of the current I output by the ammeter 9 according to a sampling period $T_1$ of the ammeter, and acquires in real time data of the liquid level height h output by the ultrasonic level meter 12 according to a sampling period $T_2$ of the ultrasonic level meter. The sampling duration of the computer is t1 ranging from 30T-50T, wherein T is a larger value of $T_1$ and $T_2$.

During the system test, the computer acquires the data of the current I and the liquid level height h within the sampling duration t1 to respectively generate arrays $I1=[I1_1, I1_2, ..., I1_n]$ and $h1=[h1_1, h1_2, ..., h1_n]$. The computer firstly calculates coefficients of fluctuation $S1_{h1} = \frac{\max(h1)-\min(h1)}{\overline{h1}}$ and $S2_{h1} = \left|\frac{h1_m}{\overline{h1}}\right|$ of the array h1, wherein max(h1) is the maximum value in the array h1, min(h1) is the minimum value in the array h1, $\overline{h1} = \frac{\sum_{i=1}^{n} h1_i}{n}$, and $h1_m$ is the median of the array h1.

When the coefficients of fluctuation $S1_{h1}$ and $S2_{h1}$ satisfy both the conditions $S1_{h1} \leq 6\%$ and $97\% \leq S2_{h1} \leq 103\%$, the computer processes the arrays I1 and h1, respectively acquires through calculation the mean values $\overline{I1} = \frac{\sum_{i=1}^{n} I1_i}{n}$ and $\overline{h1} = \frac{\sum_{i=1}^{n} h1_i}{n}$ of the arrays I1 and h1, and outputs $\overline{I1}$ and $\overline{h1}$ as the real-time current value and the real-time liquid level height of this spray test respectively. When the coefficients of fluctuation $S1_{h1}$ and $S2_{h1}$ fail to satisfy both the conditions $S1_{h1} \leq 6\%$ and $97\% < S2_{h1} < 103\%$, the computer still outputs $\overline{I1}$ and $\overline{h1}$ as the real-time current value and the real-time liquid level height of this spray test respectively, and meanwhile, outputs the coefficients of fluctuation $S1_{h1}$ and $S2_{h1}$ synchronously for the reference of testers.

When the measurement system is in the second working mode, the computer acquires in real time the measurement data of the ammeter, the ultrasonic level meter, and the flowmeter. The specific measurement method includes the following steps.

During the spray test of the electrostatic atomization nozzle 1, the computer acquires in real time data of the current I output by the ammeter 9 according to the sampling period $T_1$ of the ammeter, acquires in real time data of the liquid level height h output by the ultrasonic level meter 12 according to the sampling period $T_2$ of the ultrasonic level meter, and acquires in real time data of the spray flow q output by the flowmeter 20 according to a sampling period $T_3$ of the flowmeter. The sampling duration of the computer is t2 ranging from 30T-50T, wherein T is the maximum value of $T_1$, $T_2$, and $T_3$.

During the system test, the computer acquires the data of the current I, the liquid level height h, and the spray flow q within the sampling duration t2 to respectively generate arrays $I2=[I2_1, I2_2, ..., I2_n]$, $h2=[h2_1, h2_2, ..., h2_n]$, and

q1=[q1$_1$, q1$_2$, ..., q1$_{n]}$. The computer firstly calculates coefficients of fluctuation $S1_{h2} = \frac{\max(h2)-\min(h2)}{\overline{h2}}$ , $S2_{h2} = \left|\frac{h2_m}{\overline{h2}}\right|$, $S1_{q1} = \frac{\max(q1)-\min(q1)}{\overline{q1}}$ , and $S2_{q1} = \left|\frac{q1_m}{\overline{q1}}\right|$ of the arrays h2 and q1, wherein max(h2) is the maximum value in the array h2, min(h2) is the minimum value in the array h2, $\overline{h2} = \frac{\sum_{i=1}^n h2_i}{n}$ and h2$_m$ is the median of the array h2, max(q1) is the maximum value in the array q1, min(q1) is the minimum value in the array q1, $\overline{q1} = \frac{\sum_{i=1}^n q1_i}{n}$ and q1$_m$ is the median of the array q1.

When the coefficients of fluctuation $S1_{h2}$, $S2_{h2}$, $S1_{q1}$, and $S2_{q1}$ satisfy all the conditions $S1_{h2} \leq 6\%$, $97\% \leq S2_{h2} \leq 103\%$, $S1_{q1} \leq 3\%$, and $98\% \leq S2_{q1} \leq 102\%$, the computer processes the arrays l2 and h2, respectively acquires through calculation the mean values $\overline{l2} = \frac{\sum_{i=1}^n l2_i}{n}$ and $\overline{h2} = \frac{\sum_{i=1}^n h2_i}{n}$ of the arrays l2 and h2, and outputs $\overline{l2}$ and $\overline{h2}$ as the real-time current value and the real-time liquid level height of this spray test respectively. When the coefficients of fluctuation $S1_{h2}$, $S2_{h2}$, $S1_{q1}$, and $S2_{q1}$ fail to satisfy all the conditions $S1_{h2} \leq 6\%$, $97\% \leq S2_{h2} \leq 103\%$, $S1_{q1} \leq 3\%$, and $98\% \leq S2_{q1} \leq 102\%$, the computer still outputs $\overline{l2}$ and $\overline{h2}$ as the real-time current value and the real-time liquid level height of this spray test respectively, and meanwhile, outputs the coefficients of fluctuation $S1_{h2}$, $S2_{h2}$, $S1_{q1}$, and $S2_{q1}$ synchronously for the reference of testers.

During the test, the computer system calculates the charge-to-mass ratio parameter of the electrostatic atomization nozzle according to the real-time current value and the real-time liquid level height output in the spray test. The charge-to-mass ratio parameter is specifically calculated by using the following formula:

$$\varepsilon = k_1 \frac{\overline{l1}}{\rho d_1^2 \sqrt{g\overline{h1}}} = k_1 \frac{\overline{l2}}{\rho d_1^2 \sqrt{g\overline{h2}}}$$

wherein $\varepsilon$, in microcoulombs/kilogram, is the charge-to-mass ratio parameter of the electrostatic atomization nozzle;

$\rho$, in kilograms/cubic meter, is the density of the liquid to be sprayed by the electrostatic atomization nozzle;
$d_1$, in meters, is the inner diameter of the lower-cylinder water outlet pipe;
g, in meters/second squared, is gravitational acceleration;
$k_1$ is modification coefficient, $k_1$=1080-1120;
$\overline{l1}$ and $\overline{l2}$, in amperes, are real-time current values during the test of the measurement system;
$\overline{h1}$ and $\overline{h2}$, in meters, are real-time liquid level heights during the test of the measurement system.

**Claims**

1. A system for measuring a charge-to-mass ratio of an electrostatic atomization nozzle (1), comprising an electrostatic atomization nozzle (1), an insulating bracket (2), an upper cylinder (3), a water retaining ring (4), a vortex breaker (5), a flow regulating plate (6), a lower cylinder (7), a lower-cylinder water outlet pipe (8), an ammeter (9), a metal conducting wire (10), a liquid level tube (11), an ultrasonic level meter (12), a water storage tank (13), a water supply pipe (14), a liquid pump (15), a branch pipeline (16), a pressure regulating valve (17), a throttle valve (18), a filter (19), a flowmeter (20), and a computer, **characterized in that** the upper cylinder (3) is formed by circumferentially connecting a gradually expanding upper-cylinder end cover (23) and a thin-walled columnar upper-cylinder main body (25), a lower end of the upper cylinder (3) is an opening, an upper end of the upper cylinder (3) is the upper-cylinder end cover (23), and an end-cover central hole (22) is provided at a center of the upper-cylinder end cover (23); the lower cylinder (7) is formed by circumferentially welding a thin-walled columnar lower-cylinder main body (28) and a gradually reducing lower-cylinder bottom cover (29), an upper end of the lower cylinder (7) is an opening, and a lower end of the lower-cylinder bottom cover (29) is connected to the lower-cylinder water outlet pipe (8); the upper cylinder (3) and the lower cylinder (7) are connected through an upper-cylinder flange (26) and a lower-cylinder flange (27), thereby forming an internal cylindrical space with two open ends between the upper cylinder (3) and the lower cylinder (7); the electrostatic atomization nozzle (1), the upper cylinder (3), and the lower cylinder (7) are sequentially connected from top to bottom, and the electrostatic atomization nozzle (1) is mounted in middle of the end-cover central hole (22) and sprays charged droplets vertically downward; the ammeter (9) is connected to the lower-cylinder flange (27) through the metal conducting wire (10), and is capable of measuring in real time a current produced by the charged droplets sprayed by the electrostatic atomization nozzle (1) into the lower cylinder (7); the charged droplets sprayed by the electrostatic atomization nozzle (1) are gathered in the lower cylinder (7), and under influence of its own gravity, the liquid flows to the water storage tank (13) through the lower-cylinder water outlet pipe (8), while a bottom end of the water storage tank (13) is communicated with the water supply pipe (14) and the liquid pump (15), enabling the liquid in the water storage tank (13) to be delivered by the liquid pump (15) to an inlet of the electrostatic atomization nozzle (1) and again sprayed into the lower cylinder (7) by the electrostatic atomization nozzle (1); the water supply pipe (14) is communicated with the branch pipeline (16), and a part of the liquid delivered by the liquid pump (15) flows back to the water storage tank (13) through the branch pipeline (16); the liquid level tube (11) is L-shaped and consists of a horizontal short tube (34) and a vertical long tube (35) which have thin-walled round tubular structures, the horizontal short tube (34) is communicated with the lower cylinder (7), and the ultrasonic level meter (12) is mounted on an upper end of the vertical long tube (35) and is capable of measuring in real time a liquid level height in the liquid level tube (11) and the lower cylinder (7); the ammeter (9), the ultrasonic level meter (12), and the flowmeter (20) are connected to the computer through data cables, and the computer acquires and processes in real time measurement data of the ammeter (9), the ultrasonic level meter (12), and the flowmeter (20), thereby achieving real-time measurement and monitoring of the charge-to-mass ratio parameter of the electrostatic atomization nozzle (1).

2. The system for measuring the charge-to-mass ratio of the electrostatic atomization nozzle (1) according to claim 1, **characterized in that** the upper cylinder (3) is fixed to a top fixing end through the insulating bracket (2), and an inner diameter of the upper-cylinder main body (25) is equal to an inner diameter $D_1$ of the lower-cylinder main body (28); the water retaining ring (4) is of a thin-walled columnar structure coaxial with the upper cylinder (3) and is located in the upper cylinder (3), and an upper end surface of the water retaining ring (4) is connected to a lower surface of the upper-cylinder end cover (23); an inner diameter of the water retaining ring (4) is a half of the inner diameter $D_1$ of the lower-cylinder main body (28); several end-cover vent holes (24) are provided on an edge of the upper-cylinder end cover (23), so that the internal cylindrical space formed between the upper cylinder (3) and the lower cylinder (7) is open to atmosphere, and the end-cover vent holes (2) are uniformly distributed along a circumference of the edge of the upper-cylinder end cover (23); the insulating bracket (2), the upper cylinder (3), and the water retaining ring (4) are made of an insulating material; the vortex breaker (5) and the flow regulating plate (6) are disposed in the lower-cylinder main body (28), the vortex breaker (5) is of a crossed structure formed by flat steel bars, and the flow regulating plate (6) is of a circular steel plate structure provided with circular flow-through holes (37); the vortex breaker (5) and the flow regulating plate (6) are sequentially and horizontally arranged in the lower-cylinder main body (28) from top to bottom, and the liquid gathered in the lower cylinder (7) passes through the vortex breaker (5) and the flow regulating plate (6) in process of flowing downward; the lower-cylinder flange (27) is welded on an upper end surface of the lower-cylinder main body (28), the lower-cylinder flange (27) and the upper-cylinder flange (26) are matched and fixedly connected with each other, so that the upper cylinder (3) and the lower cylinder (7) are coaxially and fixedly connected, and a gasket is arranged between the lower-cylinder flange (27) and the upper-cylinder flange (26) to prevent leakage of the liquid; the lower cylinder (7) and the lower-cylinder water outlet pipe (8) are made of a metal material, and outer surfaces thereof are treated with polymer spraying to improve insulation performance from outside.

3. The system for measuring the charge-to-mass ratio of the electrostatic atomization nozzle (1) according to claim 2, **characterized in that** a wall of the upper cylinder (3) is 8-12 millimeters thick; the water retaining ring (4) is 2-4 millimeters thick; the insulating material comprises rubber, polyethylene, polypropylene, or polyvinyl chloride; walls of the lower cylinder (7) and the lower-cylinder water outlet pipe (8) are 5-8 millimeters thick; the metal material for fabricating the lower cylinder (7) and the lower-cylinder water outlet pipe (8) comprises carbon steel, stainless steel, and aluminum alloys.

4. The system for measuring the charge-to-mass ratio of the electrostatic atomization nozzle (1) according to claim 1, **characterized in that** the upper-cylinder main body (25) and the lower-cylinder main body (28) are of thin-walled columnar structures, and the lower-cylinder water outlet pipe (8) is of a columnar short pipe structure, wherein an inner diameter $D_1$ of the lower-cylinder main body (28) ranges from 0.3-0.6 meters, an inner diameter $d_1$ of the lower-cylinder water outlet pipe (8) ranges from 0.001 meter-0.005 meters, and a length $L_1$ of the lower-cylinder water outlet pipe (8) ranges from 4di-5di, the lower-cylinder main body (28), the lower-cylinder bottom cover (29), and the lower-cylinder water outlet pipe (8) are sequentially connected from top to bottom, and a height H of the lower cylinder (7) is designed by using the following formula:

$$H = k_1 \frac{q^2}{gd_1^4};$$

wherein H, in meters, is the height of the lower cylinder (7);

q, in cubic meters/second, is designed spray flow of the measurement system;
g, in meters/second squared, is gravitational acceleration;
$d_1$, in meters, is the inner diameter of the lower-cylinder water outlet pipe (8);
$k_1$ is modification coefficient, ki=1.6-2.4;
the flow regulating plate (6) of a circular steel plate structure is horizontally arranged in the lower-cylinder main body (28), a certain number of circular flow-through holes (37) are provided on a surface of the flow regulating plate (6), and a diameter $d_2$ of each of the circular flow-through holes (37), the number N of the circular flow-through holes (37), and the inner diameter $D_1$ of the lower-cylinder main body (28) satisfy the following relationship:

$$0.4 \ll \frac{Nd_2^2}{D_1^2} \ll 0.6$$

wherein $d_2$, in meters, is the diameter of each of the circular flow-through holes (37);
N is the number of the circular flow-through holes (37);
$D_1$, in meters, is the inner diameter of the lower-cylinder main body (28).

5. The system for measuring the charge-to-mass ratio of the electrostatic atomization nozzle (1) according to claim 1, **characterized in that** the liquid level tube (11) is located on a side surface of the lower cylinder (7) and consists of the horizontal short tube (34) and the vertical long tube (35) welded together, the horizontal short tube (34) is horizontally arranged, and the vertical long tube (35) is vertically arranged; a liquid level tube vent hole (36) is provided on an upper end of the vertical long tube (35), so that the liquid level tube (11) is open to atmosphere, and meanwhile, the horizontal short tube (34) is communicated with the lower cylinder (7), thereby forming mutual communication between the liquid level tube (11), the lower cylinder (7), and the atmosphere, wherein a center of the liquid level tube vent hole (36) is higher than an end surface of the lower-cylinder flange (27); the ultrasonic level meter (12) is mounted on the upper end of the vertical long tube (35), a probe of the ultrasonic level meter (12) faces vertically downward, and the ultrasonic level meter (12) is capable of measuring in real time the liquid level height in the liquid level tube (11) and the lower cylinder (7); the liquid level tube (11) is made of a metal material, and an outer surface thereof is treated with polymer spraying; an input end of the ammeter (9) is connected to an outer surface of the lower-cylinder flange (27) through the metal conducting wire (10), and an output end of the ammeter (9) is connected to a ground terminal; the water storage tank (13) is a cylindrical vessel having a closed bottom end and an opening upper end and is located below the lower-cylinder water outlet pipe (8), the water storage tank (13) is communicated with the inlet of the electrostatic atomization nozzle (1) through the water supply pipe (14), the liquid pump (15), the throttle valve (18), the filter (19), and the flowmeter (20), and the flowmeter (20) is located near the inlet of the electrostatic atomization nozzle (1) and acquires in real time a spray flow of the electrostatic atomization nozzle (1); the water supply pipe (14) is arranged between the liquid pump (15) and the throttle valve (18) and is connected to the branch pipeline (16); the pressure regulating valve (17) is disposed on the branch pipeline (16) and is capable of being controlled to adjust an output pressure of the liquid pump (15) and a spray pressure of the electrostatic atomization nozzle (1); an outlet of the branch pipeline (16) faces the opening upper end of the water storage tank (13), enabling a part of the liquid to flow back into the water storage tank (13) through the branch pipeline (16) and the pressure regulating valve (17); the water storage tank (13) is made of a metal material, and the water supply pipe (14) and the branch pipeline (16) are made of an insulating material.

6. The system for measuring the charge-to-mass ratio of the electrostatic atomization nozzle (1) according to claim 5, **characterized in that** a metal material for fabricating the liquid level tube (11) and the water storage tank (13) comprises carbon steel, stainless steel, and aluminum alloys; a wall of the liquid level tube (11) is 4-6 millimeters thick and is not thicker than that of the lower cylinder (7); the ammeter (9) is selected from a microammeter or picoammeter; the insulating material for fabricating the water supply pipe (14) and the branch pipeline (16) comprises rubber, polyethylene, polypropylene, or polyvinyl chloride.

7. The system for measuring the charge-to-mass ratio of the electrostatic atomization nozzle (1) according to claim 1, **characterized in that** the measurement system has the following two working modes:

first working mode, being used for measuring the charge-to-mass ratio parameter of the electrostatic atomization nozzle (1) of an electrostatic sprayer in a working state, and in this case, the electrostatic sprayer is directly connected to the electrostatic atomization nozzle (1), the electrostatic atomization nozzle (1) is a part of the electrostatic sprayer, and during a spray test, the electrostatic sprayer provides the electrostatic atomization nozzle (1) with the liquid to be sprayed; when the charge-to-mass ratio parameter of the electrostatic atomization nozzle (1) is measured in the first working mode, the liquid pump (15), the pressure regulating valve (17), and the throttle valve (18) are in a closed state;

second working mode, wherein the electrostatic atomization nozzle (1) functions as an independent component to be measured and is not connected to an external electrostatic sprayer, the liquid is driven by the liquid pump (15) to flow in closed circulation in the electrostatic atomization nozzle (1), the lower cylinder (7), the lower-cylinder water outlet pipe (8), the water storage tank (13), and the water supply pipe (14), so that the electrostatic atomization nozzle (1) is continuously supplied with the liquid to be sprayed and proceeding of the spray test is ensured, and meanwhile, the pressure regulating valve (17) is controlled to adjust an output pressure of the liquid pump (15) and a spray pressure of the electrostatic atomization nozzle (1), to realize measurement of the charge-to-mass ratio parameter under different spray pressures; when the charge-to-mass ratio parameter of the electrostatic atomization nozzle (1) is measured in the second working mode, the liquid pump (15), the pressure regulating valve (17), and the throttle valve (18) are in an open state.

8. A measurement method using the system for measuring the charge-to-mass ratio of the electrostatic atomization nozzle (1) according to claim 7, **characterized in that** when the measurement system is in the first working mode, the computer acquires in real time the measurement data of the ammeter (9) and the ultrasonic level meter (12), and the measurement method comprises specifically the following steps:

during a spray test of the electrostatic atomization nozzle (1), acquiring, by the computer, in real time data of a current I output by the ammeter (9) according to a sampling period $T_1$ of the ammeter (9), and acquiring in real time data of a liquid level height h output by the ultrasonic level meter (12) according to a sampling period $T_2$ of the ultrasonic level meter (12), a sampling duration of the computer being t1 ranging from 30T-50T, wherein T is a larger value of $T_1$ and T2;

during a system test, acquiring, by the computer, data of the current I and the liquid level height h within the sampling duration t1 to respectively generate arrays $I1=[I1_1, I1_2, ..., I1_n]$ and $h1=[h1_1, h1_2, .., h1_n]$; firstly calculating, by the computer, coefficients of fluctuation $S1_{h1} = \dfrac{\max(h1)-\min(h1)}{\overline{h1}}$ and $S2_{h1} = \left|\dfrac{h1_m}{\overline{h1}}\right|$, wherein

max(h1) is a maximum value in the array h1, min(h1) is a minimum value in the array h1, $\overline{h1} = \dfrac{\sum_{i=1}^{n} h1_i}{n}$, and $h1_m$ is a median of the array h1;

when the coefficients of fluctuation $S1_{h1}$ and $S2_{h1}$ satisfy both conditions $S1_{h1} \leq 6\%$ and $97\% < S2_{h1} < 103\%$, processing, by the computer, the arrays 11 and h1, respectively acquiring through calculation mean values $\overline{I1} = \dfrac{\sum_{i=1}^{n} I1_i}{n}$ and $\overline{h1} = \dfrac{\sum_{i=1}^{n} h1_i}{n}$ of the arrays 11 and h1, and outputting $\overline{I1}$ and $\overline{h1}$ as a real-time current value and a real-time liquid level height of this spray test respectively;

when the coefficients of fluctuation $S1_{h1}$ and $S2_{h1}$ fail to satisfy both the conditions $S1_{h1} \leq 6\%$ and $97\% \leq S2_{h1} \leq 103\%$, still outputting, by the computer, $\overline{I1}$ and $\overline{h1}$ as the real-time current value and the real-time liquid level height of this spray test respectively, and meanwhile, outputting the coefficients of fluctuation $S1_{h1}$ and $S2_{h1}$ synchronously for reference of testers; when the measurement system is in the second working mode, the computer acquires in real time the measurement data of the ammeter (9), the ultrasonic level meter (12), and the flowmeter 20, and the measurement method comprises specifically the following steps:

during the spray test of the electrostatic atomization nozzle (1), acquiring, by the computer, in real time data of the current I output by the ammeter (9) according to the sampling period $T_1$ of the ammeter (9), acquiring in real time data of the liquid level height h output by the ultrasonic level (12) meter according to the sampling period $T_2$ of the ultrasonic level meter (12), and acquiring in real time data of the spray flow q output by the flowmeter (20) according to a sampling period $T_3$ of the flowmeter (20), the sampling duration of the computer being t2 ranging from 30T-50T, wherein T is the maximum value of $T_1$, $T_2$, and $T_3$; during the system test, acquiring, by the computer, the data of the current I, the liquid level height h, and the spray flow q within the sampling duration t2 to respectively generate arrays I2=[I2$_1$, I2$_2$, ..., I2$_n$], h2=[h2i, h2$_2$, ..., h2$_n$], and q1=[q1$_1$, q1$_2$, ..., qln]; firstly calculating, by the computer, coefficients of fluctuation

$$S1_{h2} = \frac{\max(h2) - \min(h2)}{\overline{h2}}, \quad S2_{h2} = \left| \frac{h2_m}{\overline{h2}} \right|, \quad S1_{q1} = \frac{\max(q1) - \min(q1)}{\overline{q1}}, \text{ and } \quad S2_{q1} = \left| \frac{q1_m}{\overline{q1}} \right| \text{ of}$$

the arrays h2 and q1, wherein max(h2) is the maximum value in the array h2, min(h2) is the minimum value in the array h2, $\overline{h2} = \frac{\sum_{i=1}^{n} h2_i}{n}$ and h2$_m$ is the median of the array h2, max(q1) is the maximum value in the array q1, min(q1) is the minimum value in the array q1, $\overline{q1} = \frac{\sum_{i=1}^{n} q1_i}{n}$ and q1$_m$ is the median of the array q1;

when the coefficients of fluctuation $S1_{h2}$, $S2_{h2}$, $S1_{q1}$, and $S2_{q1}$ satisfy all the conditions $S1_{h2} \leq 6\%$, $97\% \leq S2_{h2} \leq 103\%$, $S1_{q1} \leq 3\%$, and $98\% \leq S2_{q1} \leq 102\%$, processing, by the computer, the arrays 12 and h2, respectively acquiring through calculation the mean values $\overline{I2} = \frac{\sum_{i=1}^{n} I2_i}{n}$ and $\overline{h2} = \frac{\sum_{i=1}^{n} h2_i}{n}$ of the arrays 12 and h2, and outputting $\overline{I2}$ and $\overline{h2}$ as the real-time current value and the real-time liquid level height of this spray test respectively;

when the coefficients of fluctuation $S1_{h2}$, $S2_{h2}$, $S1_{q1}$, and $S2_{q1}$ fail to satisfy all the conditions $S1_{h2} \leq 6\%$, $97\% \leq S2_{h2} \leq 103\%$, $S1_{q1} \leq 3\%$, and $98\% \leq S2_{q1} \leq 102\%$, still outputting, by the computer, $\overline{I2}$ and $\overline{h2}$ as the real-time current value and the real-time liquid level height of this spray test respectively, and meanwhile, outputting the coefficients of fluctuation $S1_{h2}$, $S2_{h2}$, $S1_{q1}$, and $S2_{q1}$ synchronously for the reference of testers.

9. The method according to claim 8, **characterized in that** when the measurement system is in the first working mode or the second working mode, the computer system calculates the charge-to-mass ratio parameter of the electrostatic atomization nozzle (1) according to the real-time current value and the real-time liquid level height output in the spray test, and the charge-to-mass ratio parameter is specifically calculated by using the following formula:

$$\varepsilon = k_1 \frac{\overline{I1}}{\rho d_1^2 \sqrt{g\overline{h1}}} = k_1 \frac{\overline{I2}}{\rho d_1^2 \sqrt{g\overline{h2}}}$$

wherein ε, in microcoulombs/kilogram, is the charge-to-mass ratio parameter of the electrostatic atomization nozzle (1);

ρ, in kilograms/cubic meter, is the density of the liquid to be sprayed by the electrostatic atomization nozzle (1);
$d_1$, in meters, is the inner diameter of the lower-cylinder water outlet pipe (8);
g, in meters/second squared, is gravitational acceleration;
$k_1$ is modification coefficient, ki=1080-1120;
$\overline{I1}$ and $\overline{I2}$, in amperes, are real-time current values during the test of the measurement system;
$\overline{h1}$ and $\overline{h2}$, in meters, are real-time liquid level heights during the test of the measurement system.

**Patentansprüche**

1. System zum Messen eines Ladungs-Masse-Verhältnisses einer elektrostatischen Zerstäubungsdüse (1), umfassend eine elektrostatische Zerstäubungsdüse (1), eine isolierende Halterung (2), einen oberen Zylinder (3), einen Wasserrückhaltering (4), einen Wirbelbrecher (5), eine Durchflussregulierungsplatte (6), einen unteren Zylinder (7), ein Wasserauslassrohr (8) des unteren Zylinders, einen Amperemeter (9), einen metallischen Leitdraht (10), ein Flüssigkeitsspiegelrohr (11), ein Ultraschallpegelmesser (12), einen Wasserspeichertank (13), eine Wasserzufuhrleitung (14), eine Flüssigkeitspumpe (15), eine Abzweigleitung (16) ein Druckregelventil (17), ein Drosselventil (18), ein Filter (19), ein Durchflussmesser (20) und einem Computer, **dadurch gekennzeichnet, dass** der obere Zylinder (3) durch umfangsmäßiges Verbinden einer sich allmählich erweiternden Endabdeckung (23) des oberen Zylinders und eines dünnwandigen säulenförmigen Hauptkörpers (25) des oberen Zylinders gebildet ist, wobei ein unteres Ende des oberen Zylinders (3) eine Öffnung ist und ein oberes Ende des oberen Zylinders (3) die Endabdeckung (23) des oberen Zylinders ist, und wobei ein zentrales Endabdeckungsloch (22) in einer Mitte der Endabdeckung (23) des oberen Zylinders vorgesehen ist; dass der untere Zylinder (7) durch umfangsmäßiges Verschweißen eines dünnwandigen säulenförmigen Hauptkörpers (28) des unteren Zylinders und einer sich allmählich verjüngenden Bodenabdeckung (29) des unteren Zylinders gebildet ist, wobei ein oberes Ende des unteren Zylinders (7) eine Öffnung ist und ein unteres Ende der Bodenabdeckung (29) des unteren Zylinders mit dem Wasserauslassrohr (8) des unteren Zylinders verbunden ist; dass der obere Zylinder (3) und der untere Zylinder (7) durch einen oberen Zylinderflansch (26) und einen unteren Zylinderflansch (27) verbunden sind, wodurch ein innerer zylindrischer Raum mit zwei offenen Enden zwischen dem oberen Zylinder (3) und dem unteren Zylinder (7) gebildet wird; dass die elektrostatische Zerstäubungsdüse (1), der obere Zylinder (3) und der untere Zylinder (7) nacheinander von oben nach unten verbunden sind, wobei die elektrostatische Zerstäubungsdüse (1) in der Mitte des zentrales Endabdeckungsloch (22) angebracht ist und geladene Tröpfchen senkrecht nach unten sprüht; dass das Amperemeter (9) mit dem unteren Zylinderflansch (27) durch den leitenden Metalldraht (10) verbunden ist und in der Lage ist, in Echtzeit einen Strom zu messen, der durch die geladenen Tröpfchen erzeugt wird, die durch die elektrostatische Zerstäubungsdüse (1) in der untere Zylinder (7) gesprüht werden; dass die geladenen Tröpfchen, die von der elektrostatischen Zerstäubungsdüse (1) versprüht werden, im unteren Zylinder (7) gesammelt werden, wobei die Flüssigkeit unter dem Einfluss ihrer eigenen Schwerkraft durch das Wasserauslassrohr (8) des unteren Zylinders zum Wasserspeichertank (13) fließt, während ein unteres Ende des Wasserspeichertanks (13) mit der Wasserzufuhrleitung (14) und der Flüssigkeitspumpe (15) verbunden ist, wodurch die Flüssigkeit in dem Wasserspeichertank (13) durch die Flüssigkeitspumpe (15) zu einem Einlass der elektrostatischen Zerstäubungsdüse (1) gefördert und durch die elektrostatische Zerstäubungsdüse (1) erneut in den unteren Zylinder (7) gesprüht werden kann; dass die Wasserzufuhrleitung (14) mit der Abzweigleitung (16) verbunden ist und ein Teil der von der Flüssigkeitspumpe (15) geförderten Flüssigkeit durch die Abzweigleitung (16) in den Wasserspeichertank (13) zurückfließt; dass das Flüssigkeitspegelrohr (11) L-förmig ist und aus einem horizontalen kurzen Rohr (34) und einem vertikalen langen Rohr (35) besteht, die dünnwandige runde rohrförmige Strukturen aufweisen, wobei das horizontale kurze Rohr (34) mit dem unteren Zylinder (7) in Verbindung steht, und wobei der Ultraschallpegelmesser (12) an einem oberen Ende des vertikalen langen Rohrs (35) angebracht ist und in der Lage ist, in Echtzeit eine Flüssigkeitspegelhöhe in dem Flüssigkeitspegelrohr (11) und dem unteren Zylinder (7) zu messen; dass das Amperemeter (9), das Ultraschallpegelmesser (12) und das Durchflussmesser (20) über Datenkabel mit dem Computer verbunden sind, wobei der Computer Messdaten des Amperemeter (9), des Ultraschallpegelmessers (12) und des Durchflussmessers (20) in Echtzeit erfasst und verarbeitet, wodurch eine Echtzeitmessung und -überwachung des Parameters des Ladungs-Masse-Verhältnisses der elektrostatischen Zerstäubungsdüse (1) erreicht wird.

2. System zum Messen eines Ladungs-Masse-Verhältnisses einer elektrostatischen Zerstäubungsdüse (1) nach Anspruch 1, **dadurch gekennzeichnet, dass** der obere Zylinder (3) an einem oberen Befestigungsende durch die isolierende Halterung (2) befestigt ist, wobei der Innendurchmesser des Hauptkörpers (25) des oberen Zylinders gleich einem Innendurchmesser $D_1$ des Hauptkörpers (28) des unteren Zylinders ist; dass der Wasserrückhaltering (4) eine dünnwandige Säulenstruktur koaxial zum oberen Zylinder (3) aufweist und in dem oberen Zylinder (3) angeordnet ist, wobei eine obere Endfläche des Wasserrückhalterings (4) mit einer unteren Fläche der Endabdeckung (23) des oberen Zylinders verbunden ist; wobei ein Innendurchmesser des Wasserrückhalterings (4) die Hälfte des Innendurchmessers $D_1$ des Hauptkörpers (28) des unteren Zylinders ist; dass mehrere Endabdeckung-Entlüftungslöcher (24) an einem Rand der Endabdeckung (23) des oberen Zylinders vorgesehen sind, so dass der zwischen dem oberen Zylinder (3) und dem unteren Zylinder (7) gebildete innerer zylindrischer Raum zur Atmosphäre offen ist und die Endabdeckungs-EntLüftungslöcher (2) gleichförmig entlang eines Umfangs des Randes der Endabdeckung (23) des oberen Zylinders verteilt sind; dass die isolierende Halterung (2), der obere Zylinder (3) und der Wasserrückhaltering (4) aus einem isolierenden Material hergestellt sind; dass der Wirbelbrecher (5) und die Durchflussregulierungsplatte (6) in dem Hauptkörper (28) des unteren Zylinders angeordnet sind, wobei der Wirbelbrecher (5) eine gekreuzte Struktur hat, die durch Flachstahlstangen gebildet ist, und wobei die Durchflussregulierungsplatte (6) aus einer kreisförmigen Stahlplattenstruktur besteht, die mit kreisförmigen Durchflusslöchern (37) versehen ist; dass der Wirbelbrecher (5) und die Durchflussregulierungsplatte (6) sequentiell und horizontal im Hauptkörper (28) des unteren Zylinders von oben nach unten angeordnet sind, wobei die im unteren Zylinder (7) gesammelte Flüssigkeit den Wirbelbrecher (5) und die Durchflussregulierungsplatte (6) beim Abwärtsfließen durchläuft; dass der untere Zylinderflansch (27) an einer oberen Endfläche des Hauptkörpers (28) des unteren Zylinders angeschweißt ist, wobei der untere Zylinderflansch (27) und der obere Zylinderflansch (26) aufeinander abgestimmt und fest miteinander verbunden sind, so dass der obere Zylinder (3) und der untere Zylinder (7) koaxial und fest verbunden sind, und wobei eine Dichtung zwischen dem unteren Zylinderflansch (27) und dem oberen Zylinderflansch (26) angeordnet ist, um ein Austreten der Flüssigkeit zu verhindern; dass der untere Zylinder (7) und das Wasserauslassrohr (8) des unteren Zylinders aus einem Metallmaterial hergestellt sind und ihre Außenflächen zur Verbesserung der Isolierleistung von außen mit Polymeren besprüht sind.

3. System zum Messen eines Ladungs-Masse-Verhältnisses einer elektrostatischen Zerstäubungsdüse (1) nach Anspruch 2, **dadurch gekennzeichnet, dass** eine Wand des oberen Zylinders (3) 8-12 Millimeter dick ist; wobei der Wasserrückhaltering (4) 2-4 Millimeter dick ist; wobei das Isoliermaterial aus Gummi, Polyethylen, Polypropylen oder Polyvinylchlorid besteht; dass die Wände des unteren Zylinders (7) und des Wasserauslassrohrs (8) des unteren Zylinders 5-8 Millimeter dick sind; dass das Metallmaterial für die Herstellung des unteren Zylinders (7) und des Wasserauslassrohrs (8) des unteren Zylinders Kohlenstoffstahl, Edelstahl und Aluminiumlegierungen umfasst.

4. System zum Messen des Ladungs-Masse-Verhältnisses einer elektrostatischen Zerstäubungsdüse (1) nach Anspruch 1, **dadurch gekennzeichnet, dass** der Hauptkörper (25) des oberen Zylinders und der Hauptkörper (28) des unteren Zylinders dünnwandige, säulenartige Strukturen aufweisen, wobei das Wasserauslassrohr (8) des unteren Zylinders eine säulenartige, kurze Rohrstruktur aufweist, wobei ein Innendurchmesser $D_1$ des Hauptkörpers (28) des unteren Zylinders im Bereich von 0,3-0,6 Metern liegt, wobei ein Innendurchmesser $d_1$ des Wasserauslassrohrs (8) des unteren Zylinders im Bereich von 0,001 Metern bis 0,005 Metern liegt, wobei eine Länge $L_1$ des Wasserauslassrohrs (8) des unteren Zylinders im Bereich von $4d_1$ bis $5d_1$ liegt, wobei der Hauptkörper (28) des unteren Zylinders, die Bodenabdeckung (29) des unteren Zylinders und das Wasserauslassrohr (8) des unteren Zylinders nacheinander von oben nach unten verbunden sind, wobei eine Höhe H des unteren Zylinders (7) unter Verwendung der folgenden Formel ausgelegt ist:

$$H = k_1 \frac{q^2}{gd_1^4};$$

wobei H die Höhe des unteren Zylinders (7) in Metern ist;
wobei q der für das Messsystem ausgelegte Sprühstrom in Kubikmeter/Sekunde ist;
wobei g die Gravitationsbeschleunigung in Meter/Sekunde zum Quadrat ist;
wobei $d_1$ der Innendurchmesser des Wasserauslassrohrs des unteren Zylinders (8) in Metern ist;
wobei $k_1$ der Modifikationskoeffizient ist, $k_1$=1,6-2,4;
dass die Durchflussregulierungsplatte (6) einer kreisförmigen Stahlplattenstruktur horizontal in dem Hauptkörper (28) des unteren Zylinders angeordnet ist, wobei eine bestimmte Anzahl von kreisförmigen Durchflusslöchern (37) auf einer Oberfläche der Durchflussregulierungsplatte (6) vorgesehen ist, wobei ein Durchmesser $d_2$ jedes der kreisförmigen Durchflusslöcher (37), die Anzahl N der kreisförmigen Durchflusslöcher (37) und der Innendurchmesser $D_1$ des Hauptkörpers (28) des unteren Zylinders erfüllen folgende Beziehung:

$$0.4 \ll \frac{Nd_2^2}{D_1^2} \ll 0.6$$

wobei $d_2$ der Durchmesser jedes der kreisförmigen Durchflusslöcher (37) in Metern ist;
wobei N die Anzahl der kreisförmigen Durchflusslöcher (37) ist;
wobei $D_1$, in Metern, der Innendurchmesser des unteren Zylinderhauptkörpers (28) ist.

5. System zum Messen des Ladungs-Masse-Verhältnisses einer elektrostatischen Zerstäubungsdüse (1) nach Anspruch 1, **dadurch gekennzeichnet, dass** das Flüssigkeitspegelrohr (11) an einer Seitenfläche des unteren Zylinders (7) angeordnet ist und aus dem horizontalen kurzen Rohr (34) und dem vertikalen langen Rohr (35) besteht, die miteinander verschweißt sind, wobei das horizontale kurze Rohr (34) horizontal angeordnet ist und das vertikale lange Rohr (35) vertikal angeordnet ist; dass ein Flüssigkeitspegelrohr-Entlüftungsloch (36) an einem oberen Ende des vertikalen langen Rohrs (35) vorgesehen ist, so dass das Flüssigkeitspegelrohr (11) zur Atmosphäre offen ist, und während das horizontale kurze Rohr (34) mit dem unteren Zylinder (7) kommuniziert, wodurch eine gegenseitige Verbindung zwischen dem Flüssigkeitspegelrohr (11), dem unteren Zylinder (7) und der Atmosphäre gebildet wird, wobei eine Mitte des Flüssigkeitspegelrohr-Entlüftungslochs (36) höher als ein Ende Oberfläche des unteren Zylinderflansches (27) ist; dass der Ultraschallpegelmesser (12) am oberen Ende des vertikalen langen Rohrs (35) angebracht ist, wobei eine Sonde des Ultraschallpegelmessers (12) vertikal nach unten gerichtet ist und der Ultraschallpegelmesser (12) in der Lage ist, in Echtzeit die Höhe des Flüssigkeitspegels in dem Flüssigkeitspegelrohr (11) und dem unteren Zylinder (7) zu messen; dass das Flüssigkeitspegelrohr (11) aus einem Metallmaterial hergestellt ist und eine äußere Oberfläche davon mit einem Polymerspritzen behandelt ist; wobei ein Eingangsende des Amperemeters (9) mit einer äußeren Oberfläche unteren Zylinderflansches (27) durch den metallischen Leitdraht (10) verbunden ist, und wobei ein Ausgangsende des Amperemeters (9) mit einem Erdungsanschluss verbunden ist; dass der Wasserspeichertank (13) ein zylindrischer Behälter mit einem geschlossenen unteren Ende und einem sich öffnenden oberen Ende ist und sich unter dem Wasserauslassrohr (8) des unteren Zylinders befindet, wobei der Wasserspeicher (13) mit dem Einlass der elektrostatischen Zerstäubungsdüse (1) über das Wasserzufuhrleitung (14), die Flüssigkeitspumpe (15), das Drosselventil (18), den Filter (19) und den Durchflussmesser (20) verbunden ist, wobei der Durchflussmesser (20) sich in der Nähe des Einlasses der elektrostatischen Zerstäubungsdüse (1) befindet und in Echtzeit einen Sprühstrom der elektrostatischen Zerstäubungsdüse (1) erfasst; dass die Wasserzufuhrleitung (14) zwischen der Flüssigkeitspumpe (15) und dem Drosselventil (18) angeordnet ist und mit der Abzweigleitung (16) verbunden; dass das Druckregelventil (17) an der Abzweigleitung (16) angeordnet ist und gesteuert werden kann, um einen Ausgangsdruck der Flüssigkeitspumpe (15) und einen Sprühdruck der elektrostatischen Zerstäubungsdüse (1) einzustellen; dass im Auslass der Abzweigleitung (16) dem sich öffnenden oberen Ende des Wasserspeichertanks (13) zugewandt ist, so dass ein Teil der Flüssigkeit durch die Abzweigleitung (16) und das Druckregelventil (17) in den Wasserspeichertank (13) zurückfließen kann; der Wasserspeichertank (13) aus einem Metallmaterial hergestellt ist und das Wasserzufuhrrohr (14) und die Abzweigleitung (16) aus einem Isoliermaterial hergestellt sind.

6. System zum Messen des Ladungs-Masse-Verhältnisses der elektrostatischen Zerstäubungsdüse (1) nach Anspruch 5, **dadurch gekennzeichnet, dass** ein Metallmaterial zur Herstellung des Flüssigkeitsspiegelrohrs (11) und des Wasserspeichertanks (13) Kohlenstoffstahl, Edelstahl und Aluminiumlegierungen umfasst; dass eine Wand des Flüssigkeitsspiegelrohrs (11) 4-6 Millimeter dick ist und nicht dicker als die des unteren Zylinders (7) ist; dass das Amperemeter (9) aus einem Mikroamperemeter oder Picoamperemeter ausgewählt ist; dass das Isoliermaterial zur Herstellung des Wasserzufuhrrohrs (14) und der Abzweigleitung (16) Gummi, Polyethylen, Polypropylen oder Polyvinylchlorid umfasst.

7. System zum Messen des Ladungs-Masse-Verhältnisses der elektrostatischen Zerstäubungsdüse (1) nach Anspruch 1, **dadurch gekennzeichnet, dass** das System die folgenden zwei Betriebsarten aufweist:

erster Arbeitsmodus, der zum Messen des Parameters des Ladungs-Masse-Verhältnisses der elektrostatischen Zerstäubungsdüse (1) eines elektrostatischen Zerstäubers in einem Arbeitszustand verwendet wird, wobei in diesem Fall der elektrostatische Zerstäuber direkt mit der elektrostatischen Zerstäubungsdüse (1) verbunden ist, wobei die elektrostatische Zerstäubungsdüse (1) ein Teil des elektrostatischen Zerstäubers ist, und wobei während eines Sprühtests der elektrostatische Zerstäuber die elektrostatische Zerstäubungsdüse (1) mit der zu sprühenden Flüssigkeit versorgt; wobei, wenn der Parameter des Ladungs-Masse-Verhältnisses der elektrostatischen Zerstäubungsdüse (1) in der ersten Betriebsart gemessen wird, die Flüssigkeitspumpe (15), das Druckregelventil (17) und das Drosselventil (18) in einem geschlossenen Zustand sind;
zweiter Arbeitsmodus, bei dem die elektrostatische Zerstäubungsdüse (1) als eigenständiges zu messendes Bauteil fungiert und nicht mit einem externen elektrostatischen Zerstäuber verbunden ist, wobei die Flüssigkeit durch die Flüssigkeitspumpe (15) angetrieben wird, um in einem geschlossenen Kreislauf in der elektrostatischen Zerstäubungsdüse (1), den unteren Zylinder (7), das Wasserauslassrohr des unteren Zylinders (8), den Wasserspeichertank (13) und der Wasserzufuhrleitung (14) zu fließen, so dass die elektrostatische Zerstäubungsdüse (1) kontinuierlich mit der zu versprühenden Flüssigkeit versorgt wird und der Ablauf des Sprühtests sichergestellt ist, und wobei währenddessen das Druckregelventil (17) gesteuert wird, um einen Ausgangsdruck der Flüssigkeitspumpe (15) und einen Sprühdruck der elektrostatischen Zerstäubungsdüse einzustellen (1), um eine Messung des Parameters des Ladungs-Masse-Verhältnisses unter verschiedenen Sprühdrücken zu realisieren; wobei, wenn der Parameter des Ladungs-zu-Masse-Verhältnisses der elektrostatischen Zerstäubungsdüse (1) im zweiten Arbeitsmodus gemessen wird, die Flüssigkeitspumpe (15), das Druckregelventil (17) und das Drosselventil (18) in einem offener Zustand sind.

8. Messverfahren unter Verwendung des Systems zum Messen des Ladungs-Masse-Verhältnisses der elektrostatischen Zerstäubungsdüse (1) nach Anspruch 7, **dadurch gekennzeichnet, dass**, wenn sich das System im ersten Arbeitsmodus befindet, der Computer in Echtzeit die Messdaten des Amperemeters (9) und des Ultraschallpegelmessers (12) erfasst, und wobei das Messverfahren insbesondere die folgenden Schritte umfasst:

während eines Sprühtests der elektrostatischen Zerstäubungsdüse (1), Erfassen, durch den Computer in Echtzeit, von Daten eines Stroms I, der durch das Amperemeter (9) gemäß einer Abtastperiode $T_1$ des Amperemeters (9) ausgegeben wird, und Erfassen Echtzeitdaten einer Flüssigkeitspegelhöhe h, die vom Ultraschallpegelmesser (12) gemäß einer Abtastperiode $T_2$ des Ultraschallpegelmessers (12) ausgegeben werden, wobei eine Abtastdauer t1 des Computers im Bereich von 30T-50T beträgt, wobei T ein größerer Wert von $T_1$ und $T_2$ ist;
während eines Systemtests, Erfassen von Daten des Stroms I und der Flüssigkeitspegelhöhe h innerhalb der Abtastdauer t1 durch den Computer, um jeweils Arrays I1=[I1$_1$, I1$_2$, ..., I1$_n$] und h1=[h1$_1$, h1$_2$, ..., h1$_n$] zu erzeugen; zunächst Berechnen von Fluktuationskoeffizienten $S1_{h1} = \dfrac{\max(h1)-\min(h1)}{\overline{h1}}$ und $S2_{h1} = \left|\dfrac{h1_m}{\overline{h1}}\right|$ durch den Computer, wobei max(h1)ein Maximalwert in dem Array h1 ist, min(h1)ein Minimalwert in dem Array h1 ist, $\overline{h1} = \dfrac{\sum_{i=1}^{n} h1_i}{n}$, und h1$_m$ein Median des Arrays h1 ist;
wenn die Schwankungskoeffizienten $S1_{h1}$ und $S2_{h1}$ beide Bedingungen $S1_{h1} \leq 6\%$ und $97\% \leq S2_{h1} \leq 103\%$ gleichzeitig erfüllen, Verarbeiten der Arrays I1 und h1 durch den Computer, wobei jeweils Mittelwerte $\overline{I1} = \dfrac{\sum_{i=1}^{n} I1_i}{n}$ und $\overline{h1} = \dfrac{\sum_{i=1}^{n} h1_i}{n}$ des Arrays I1 und h1 durch Berechnung erfasst werden, und Ausgeben von $\overline{I1}$ und $\overline{h1}$ als einen Echtzeit-Stromwert bzw. eine Echtzeit-Flüssigkeitspegelhöhe dieses Sprühtests;
wenn die Schwankungskoeffizienten $S1_{h1}$ und $S2_{h1}$nicht sowohl die Bedingungen $S1_{h1} \leq 6\%$ und $97\% \leq S2_{h1} \leq 103\%$ erfüllen, noch Ausgeben, durch den Computer, $\overline{I1}$ und $\overline{h1}$ als die Echtzeit-Stromwert und die Echtzeit-Flüssigkeitspegelhöhe dieser Spray-Test bzw., und inzwischen synchron Ausgeben der Schwankungskoeffizienten $S1_{h1}$ und $S2_{h1}$ für die Referenz der Tester;
wenn sich das Messsystem im zweiten Arbeitsmodus befindet, erfasst der Computer in Echtzeit die Messdaten des Amperemeters (9), des Ultraschallpegelmessers (12) und des Durchflussmessers (20), und das Messverfahren umfasst insbesondere die folgenden Schritte:

während des Sprühtests der elektrostatischen Zerstäubungsdüse (1), Erfassen von Echtzeitdaten des Stroms I, der von dem Amperemeter (9) gemäß der Abtastperiode $T_1$ des Amperemeters (9) ausgegeben wird, Erfassen von Echtzeitdaten der Flüssigkeitspegelhöhe h, die von dem Ultraschallpegelmesser (12) gemäß der Abtastperiode $T_2$ des Ultraschallpegelmessers (12) ausgegeben wird, durch den Computer, und Erfassen von Echtzeitdaten des von dem Durchflussmesser (20) ausgegebenen Sprühstroms q gemäß einer Abtastperiode $T_3$ des Durchflussmessers (20), wobei die Abtastdauer des Computers t2 im Bereich von 30T-50T liegt, wobei T der Maximalwert von $T_1$, $T_2$ und $T_3$ ist;
während des Systemtests, Erfassen der Daten des Stroms I, der Flüssigkeitspegelhöhe h und des Sprühstroms q innerhalb der Abtastdauer t2 durch den Computer, um jeweils Arrays I2=[I2$_1$, I2$_2$, ..., I2$_n$], h2=[h2$_1$, h2$_2$, ..., h2n], und q1=[q1$_1$, q1$_2$, ..., qln]; zunächst Berechnen von Schwankungskoeffizienten $S1_{h2} = \dfrac{\max(h2)-\min(h2)}{\overline{h2}}$, $S2_{h2} = \left|\dfrac{h2_m}{\overline{h2}}\right|$, $S1_{q1} = \dfrac{\max(q1)-\min(q1)}{\overline{q1}}$ und von $S2_{q1} = \left|\dfrac{q1_m}{\overline{q1}}\right|$ der Arrays h2 und q1 durch den Computer, wobei max(h2) der Maximalwert in dem Array h2 ist, min(h2) der Minimalwert in dem Array h2 ist, $\overline{h2} = \dfrac{\sum_{i=1}^{n} h2_i}{n}$, h2$_m$ der Median des Array h2 sind, max(q1) der Maximalwert in dem Array q1 ist, min(q1) der Minimalwert in dem Array q1 ist und $\overline{q1} = \dfrac{\sum_{i=1}^{n} q1_i}{n}$ und q1$_m$ der Median des Arrays q1 sind;

wenn die Schwankungskoeffizienten $S1_{h2}$, $S2_{h2}$, $S1_{q1}$ und $S2_{q1}$ alle Bedingungen $S1_{h2}{\leq}6\%$, $97\%{\leq}S2_{h2}{\leq}103\%$, $S1_{q1}{\leq}3\%$ und $98\%{\leq}S2_{q1}{\leq}102\%$ erfüllen, Verarbeiten des Arrays I2 und h2 durch den

$$\overline{I2} = \frac{\sum_{i=1}^{n} I2_i}{n} \qquad \overline{h2} = \frac{\sum_{i=1}^{n} h2_i}{n}$$

Computer, Erfassen der Mittelwerte und des Arrays I2 und h2 durch Berechnung und Ausgeben von $\overline{I2}$ und $\overline{h2}$ als Echtzeit-Stromwert bzw. Echtzeit-Flüssigkeitspegelhöhe dieses Sprühtests;

wenn die Schwankungskoeffizienten $S1_{h2}$, $S2_{h2}$, $S1_{q1}$ und $S2_{q1}$ nicht alle Bedingungen $S1_{h2}{\leq}6\%$, $97\%{\leq}S2_{h2}{\leq}103\%$, $S1_{q1}{\leq}3\%$, und $98\%{\leq}S2_{q1}{\leq}102\%$ erfüllen, noch Ausgeben, durch den Computer, $\overline{I2}$ und $\overline{h2}$ als die Echtzeit-Stromwert und die Echtzeit-Flüssigkeitspegelhöhe dieser Spray-Test, und inzwischen, synchron Ausgeben der Schwankungskoeffizienten $S1_{h2}$, $S2_{h2}$, $S1_{q1}$ und $S2_{q1}$ für die Referenz der Tester.

9. Verfahren nach Anspruch 8, **dadurch gekennzeichnet, dass**, wenn sich das Messsystem im ersten Arbeitsmodus oder im zweiten Arbeitsmodus befindet, das Computersystem den Ladungs-Masse-Verhältnis-Parameter der elektrostatischen Zerstäubungsdüse (1) gemäß dem Echtzeit-Stromwert und der Echtzeit-Flüssigkeitspegelhöhe berechnet, die im Sprühtest ausgegeben werden, und der Ladungs-Masse-Verhältnis-Parameter speziell unter Verwendung der folgenden Formel berechnet wird:

$$\varepsilon = k_1 \frac{\overline{I1}}{\rho d_1^2 \sqrt{g\overline{h1}}} = k_1 \frac{\overline{I2}}{\rho d_1^2 \sqrt{g\overline{h2}}}$$

wobei $\varepsilon$, in Mikrocoulomb/Kilogramm, der Parameter des Ladungs-Masse-Verhältnisses der elektrostatischen Zerstäubungsdüse (1) ist;
wobei $\rho$, in Kilogramm/Kubikmeter, die Dichte der Flüssigkeit ist, die von der elektrostatischen Zerstäubungsdüse (1) versprüht werden soll;
wobei $d_1$ der Innendurchmesser des Wasserauslassrohrs des unteren Zylinders (8) in Metern ist;
wobei g die Gravitationsbeschleunigung in Meter/Sekunde zum Quadrat ist;
wobei $k_1$ der Modifikationskoeffizient ist, $k_1{=}1080{-}1120$;
wobei $\overline{I1}$ und $\overline{I2}$ Echtzeit-Stromwerte während der Prüfung des Messsystems in Ampere sind;
wobei $\overline{h1}$ und $\overline{h2}$ Echtzeit-Flüssigkeitspegelhöhe während des Tests des Messsystems in Metern sind.

## Revendications

1. Système de mesure d'un rapport charge/masse d'une buse de pulvérisation électrostatique (1), comprenant une buse de pulvérisation électrostatique (1), un support isolant (2), un cylindre supérieur (3), une bague de retenue d'eau (4), un brise-vortex (5), une plaque de régulation de débit (6), un cylindre inférieur (7), un tuyau de sortie d'eau de cylindre inférieur (8), un ampèremètre (9), un fil conducteur métallique (10), un tuyau de niveau liquide (11), un indicateur de niveau à ultrasons (12), une cuve de stockage d'eau (13), un tuyau d'alimentation en eau (14), une pompe à liquide (15), une tuyauterie de dérivation (16), une vanne de régulation de pression (17), une vanne des gaz (18), un filtre (19), un débitmètre (20) et un ordinateur, **caractérisé en ce que** le cylindre supérieur (3) est formé en connectant de manière circonférentielle un couvercle d'extrémité expansible de cylindre supérieur (23) et un corps principal cylindrique à parois minces de cylindre supérieur (25), une extrémité inférieure de cylindre supérieur (3) est une ouverture, une extrémité supérieure de cylindre supérieur (3) est le couvercle d'extrémité de cylindre supérieur (23), et un trou central de couvercle d'extrémité (22) est prévu au centre du couvercle d'extrémité de cylindre supérieur (23); le cylindre inférieur (7) est formé par soudage circonférentiel d'un corps principal cylindrique à parois minces de cylindre inférieur (28) et d'un couvercle inférieur réduisant progressivement de cylindre inférieur (29), une extrémité supérieure du cylindre inférieur (7) est une ouverture, et une extrémité inférieure du couvercle inférieur de cylindre inférieur (29) est connectée au tuyau de sortie d'eau de cylindre inférieur (8); le cylindre supérieur (3) et le cylindre inférieur (7) sont connectés par l'intermédiaire d'une bride de cylindre supérieur (26) et d'une bride de cylindre inférieur (27), formant ainsi un espace cylindrique interne avec deux extrémités ouvertes entre le cylindre supérieur (3 ) et le cylindre inférieur (7); la buse de pulvérisation électrostatique (1), le cylindre supérieur (3) et le cylindre inférieur (7) sont connectés en séquence de haut en bas, et la buse de pulvérisation électrostatique (1) est montée au milieu du trou central de couvercle d'extrémité (22) et pulvérise des gouttelettes chargées verticalement vers le bas; l'ampèremètre (9) est connecté à la bride de cylindre inférieure (27) par l'intermédiaire du fil conducteur métallique (10), et est capable de mesurer en temps réel un courant généré par les gouttelettes chargées pulvérisées par la buse de pulvérisation électrostatique (1) dans le cylindre inférieur (7); les gouttelettes chargées pulvérisées par la buse de pulvérisation électrostatique (1) sont recueillies dans le cylindre inférieur (7) sous sa propre gravité, le liquide s'écoule vers la cuve de stockage d'eau (13) à travers le tuyau de sortie d'eau de cylindre inférieur (8), tandis qu'une extrémité inférieure de la cuve de stockage d'eau (13) est en communication avec le tuyau d'alimentation en eau (14) et la pompe à liquide (15), permettant au liquide dans la cuve de stockage d'eau (13) d'être évacué par la pompe à liquide (15) vers une entrée de la buse de pulvérisation électrostatique (1) et de repulvérisée dans le cylindre inférieur (7) par la buse de pulvérisation électrostatique (1); le tuyau d'alimentation en eau (14) est en communication avec la tuyauterie de dérivation (16), et une partie du liquide évacué par la pompe à liquide (15) reflue vers la cuve de stockage d'eau (13) à travers la tuyauterie de dérivation (16); le tuyau de niveau de liquide (11) est en forme L et se constitue d'un tuyau court horizontal (34) et d'un tuyau long vertical (35) ayant chacun une structure tubulaire ronde à paroi mince, le tuyau court horizontal (34) est en communication avec le cylindre inférieur (7), et l'indicateur de niveau à ultrasons (12) est monté à une extrémité supérieure du tuyau long vertical (35) et est capable de mesurer en temps réel une hauteur de niveau de liquide dans le tuyau de niveau de liquide (11) et le cylindre inférieure (7); l'ampèremètre (9), l'indicateur de niveau à ultrasons (12) et le débitmètre (20) sont connectés à l'ordinateur par l'intermédiaire des câbles de données, et l'ordinateur acquiert et traite en temps réel les données de mesure de l'ampèremètre (9), de l'indicateur de niveau à ultrasons (12) et du débitmètre (20), réalisant ainsi une mesure et une surveillance en temps réel du paramètre de rapport charge/masse de la buse de pulvérisation électrostatique (1).

2. Système de mesure du rapport charge/masse de la buse de pulvérisation électrostatique (1) selon la revendication 1, **caractérisé en ce que** le cylindre supérieur (3) est fixé à une extrémité de fixation supérieure par l'intermédiaire du support isolant (2), et un diamètre interne du corps principal de cylindre supérieur (25) est égal à un diamètre interne $D_1$ du corps principal de cylindre inférieur (28); la bague de retenue d'eau (4) a une structure cylindrique à paroi mince coaxiale au cylindre supérieur (3) et est disposé dans le cylindre supérieur (3), et une surface d'extrémité supérieure de la bague de retenue d'eau (4) est connectée à une surface inférieure du couvercle d'extrémité de cylindre supérieur (23); un diamètre interne de la bague de retenue d'eau (4) est égal à la moitié du diamètre interne $D_1$ du corps principal de cylindre inférieur (28); plusieurs trou d'éventage de couvercle d'extrémité (24) sont prévus sur un bord du couvercle d'extrémité de cylindre supérieur (23), de sorte que l'espace cylindrique interne formé entre le cylindre supérieur (3) et le cylindre inférieur (7) soit ouvert à l'atmosphère, et les trous d'éventage de couvercle d'extrémité (2) sont répartis de manière uniforme le long d'une circonférence du bord du couvercle d'extrémité de cylindre supérieur (23); le support isolant (2), le cylindre supérieur (3) et la bague de retenue d'eau (4) sont réalisés en un matériau isolant; le brise-vortex (5) et la plaque de régulation de débit (6) sont disposés dans le corps principal de cylindre inférieur (28), le brise-vortex (5) a une structure croisée formée par des barres d'acier plates, et la plaque de régulation de débit (6) a une structure en tôle d'acier circulaire pourvue de trous traversants circulaires d'écoulement (37); le brise-vortex (5) et la plaque de régulation de débit (6) sont disposés en séquence de haut en bas et horizontalement dans le corps principal de cylindre inférieur (28), et le liquide recueilli dans le cylindre inférieur (7) passe à travers le brise-vortex (5) et la plaque de régulation de débit (6) lors d'un écoulement vers le bas; la bride de cylindre inférieur (27) est soudée sur une surface d'extrémité supérieure du corps principal de cylindre inférieur (28), la bride de cylindre inférieur (27) et la bride de cylindre supérieur (26) sont appariées et connectées de manière fixe l'une à l'autre, de sorte que le cylindre supérieur (3) et le cylindre inférieur (7) soient connectés de manière coaxiale et fixe, et un joint est disposé entre la bride de cylindre inférieur (27) et la bride de cylindre supérieur (26) pour éviter toute fuite de le liquide ; le cylindre inférieur (7) et le tuyau de sortie d'eau de cylindre inférieur (8) sont réalisés en un matériau métallique, et leurs surfaces extérieures sont traitées par pulvérisation de polymère pour améliorer les performances d'isolation de l'extérieur.

3. Système de mesure du rapport charge/masse de la buse de pulvérisation électrostatique (1) selon la revendication 2, **caractérisé en ce qu'**une paroi du cylindre supérieur (3) a une épaisseur de 8 à 12 millimètres; la bague de retenue d'eau (4) a une épaisseur de 2 à 4 millimètres; le matériau isolant comprend le caoutchouc, le polyéthylène, le polypropylène ou le chlorure de polyvinyle ; les parois du cylindre inférieur (7) et le tuyau de sortie d'eau de cylindre inférieur (8) ont une épaisseur de 5 à 8 millimètres; le matériau métallique pour réaliser le cylindre inférieur (7) et le tuyau de sortie d'eau de cylindre inférieur (8) comprend l'acier au carbone, l'acier inoxydable et des alliages d'aluminium.

4. Système de mesure du rapport charge/masse de la buse de pulvérisation électrostatique (1) selon la revendication 1, **caractérisé en ce que** le corps principal de cylindre supérieur (25) et le corps principal de cylindre inférieur (28) ont une structure cylindrique à parois fines, et le tuyau de sortie d'eau de cylindre inférieur (8) a une structure de tuyau court cylindrique, dans lequel un diamètre interne $D_1$ du corps principal de cylindre inférieur (28) est compris entre 0,3 et 0,6 mètre, un diamètre interne $d_1$ du tuyau de sortie d'eau de cylindre inférieur (8) est compris entre 0,001 mètre et 0,005 mètre, et une longueur $L_1$ du tuyau de sortie d'eau de cylindre inférieur (8) est comprise entre $4d_1$ et $5d_1$, le corps principal de cylindre inférieur (28), le couvercle inférieur de cylindre inférieur (29) et le tuyau de sortie d'eau de cylindre inférieur (8) sont connectés en séquence de haut en bas, et une hauteur H du cylindre inférieur (7) est conçue en fonction de la formule suivante:

$$H = k_1 \frac{q^2}{gd_1^4};$$

où H, en mètres, est la hauteur du cylindre inférieur (7);
q, en mètres cubes/seconde, est le débit de pulvérisation prévu du système de mesure;
g, en mètres/seconde au carré, est l'accélération gravitationnelle;
$d_1$, en mètres, est le diamètre interne du tuyau de sortie d'eau de cylindre inférieur (8);
$k_1$ est un coefficient de correction, $k_1$=1.6-2.4 ;
la plaque de régulation de débit (6) ayant une structure en tôle d'acier circulaire est disposée horizontalement dans le corps principal de cylindre inférieur (28), un certain nombre de trous traversants circulaires d'écoulement (37) sont prévus sur une surface de la plaque de régulation de débit (6), et un diamètre $d_2$ de chacun des trous traversants circulaires d'écoulement (37), le nombre N des trous traversants circulaires d'écoulement (37) et le diamètre interne $D_1$ du corps principal de cylindre inférieur (28) satisfont la relation suivante :

$$0.4 \ll \frac{Nd_2^2}{D_1^2} \ll 0.6$$

où $d_2$, en mètres, est le diamètre de chacun des trous traversants circulaires d'écoulement (37);
N est le nombre de trous traversants circulaires d'écoulement (37) ; et
$D_1$, en mètres, est le diamètre interne du corps principal de cylindre inférieur (28).

**5.** Système de mesure du rapport charge/masse de la buse de pulvérisation électrostatique (1) selon la revendication 1, **caractérisé en ce que** le tuyau de niveau de liquide (11) est situé sur une surface latérale du cylindre inférieur (7) et est constitué du tuyau court horizontal (34) et du tuyau long vertical (35) soudés ensemble, le tuyau court horizontal (34) est disposé horizontalement et le tuyau long vertical (35) est disposé verticalement; un trou d'éventage de tuyau de niveau de liquide (36) est prévu sur une extrémité supérieure du long tuyau vertical (35), de sorte que le tuyau de niveau de liquide (11) soit ouvert à l'atmosphère, et de plus, le tuyau court horizontal (34) est en communication avec le cylindre inférieur (7), formant ainsi une intercommunication entre le tuyau de niveau de liquide (11), le cylindre inférieur (7) et l'atmosphère, dans lequel un centre du trou d'éventage du tuyau de niveau de liquide (36) est plus haut qu'une surface d'extrémité de la bride de cylindre inférieur (27); l'indicateur de niveau à ultrasons (12) est monté à l'extrémité supérieure du tuyau long vertical (35), une sonde de l'indicateur de niveau à ultrasons (12) est orientée verticalement vers le bas, et l'indicateur de niveau à ultrasons (12) est capable de mesurer en temps réel la hauteur de niveau de liquide dans le tuyau de niveau de liquide (11) et le cylindre inférieur (7); le tuyau de niveau de liquide (11) est réalisé en un matériau métallique, et une surface externe de celui-ci est traitée par pulvérisation de polymère; une extrémité d'entrée de l'ampèremètre (9) est connectée à une surface externe de la bride de cylindre inférieur (27) par l'intermédiaire du fil conducteur métallique (10), et une extrémité de sortie de l'ampèremètre (9) est connectée à une borne de mise à la terre; la cuve de stockage d'eau (13) est un récipient cylindrique ayant une extrémité inférieure fermée et une extrémité supérieure ouverte et est situé au-dessous du tuyau de sortie d'eau de cylindre inférieur (8), la cuve de stockage d'eau (13) est en communication avec l'entrée de la buse de pulvérisation électrostatique (1) par l'intermédiaire du tuyau d'alimentation en eau (14), de la pompe à liquide (15), de la vanne des gaz (18), du filtre (19) et du débitmètre (20), et le débitmètre (20) est situé à proximité de l'entrée de la buse de pulvérisation électrostatique (1) et acquiert en temps réel un débit de pulvérisation de la buse de pulvérisation électrostatique (1); le tuyau d'alimentation en eau (14) est disposé entre la pompe à liquide (15) et la vanne des gaz (18) et est connecté à la tuyauterie de dérivation (16); la vanne de régulation de pression (17) est disposée sur la tuyauterie de dérivation (16) et est adaptée d'être commandée pour ajuster une pression de sortie de la pompe à liquide (15) et une pression de pulvérisation de la buse de pulvérisation électrostatique (1); une sortie de la tuyauterie de dérivation (16) fait face à l'extrémité supérieure ouverte de la cuve de stockage d'eau (13), permettant à une partie du liquide de refluer dans la cuve de stockage d'eau (13) à travers la tuyauterie de dérivation (16) et la vanne de régulation de pression (17); la cuve de stockage d'eau (13) est réalisée en un matériau métallique, et le tuyau d'alimentation en eau (14) et la tuyauterie de dérivation (16) sont réalisés en un matériau isolant.

6. Système de mesure du rapport charge/masse de la buse de pulvérisation électrostatique (1) selon la revendication 5, **caractérisé en ce qu'**un matériau métallique pour réaliser le tuyau de niveau de liquide (11) et la cuve de stockage d'eau (13) contient l'acier au carbone, l'acier inoxydable et des alliages d'aluminium; une paroi du tuyau de niveau de liquide (11) a une épaisseur qui est de 4 à 6 millimètres et n'est supérieure à celle du cylindre inférieur (7); l'ampèremètre (9) est choisi parmi un micro-ampèremètre ou un pico-ampèremètre ; le matériau isolant pour réaliser le tuyau d'alimentation en eau (14) et la tuyauterie de dérivation (16) comprend le caoutchouc, le polyéthylène, le polypropylène ou le chlorure de polyvinyle.

7. Système de mesure du rapport charge/masse de la buse de pulvérisation électrostatique (1) selon la revendication 1, **caractérisé en ce que** le système de mesure fonctionne en deux modes de fonctionnement suivants :

    un premier mode de fonctionnement, utilisé pour mesurer le paramètre de rapport charge/masse de la buse de pulvérisation électrostatique (1) d'un pulvérisateur électrostatique dans un état de fonctionnement, et dans ce cas, le pulvérisateur électrostatique est connecté de manière directe à la buse de pulvérisation électrostatique (1), la buse de pulvérisation électrostatique (1) fait partie du pulvérisateur électrostatique, et pendant un test de pulvérisation, le pulvérisateur électrostatique fournit le liquide à pulvériser à la buse de pulvérisation électrostatique (1);
    lorsque le paramètre de rapport charge/masse de la buse de pulvérisation électrostatique (1) est mesuré en le premier mode de fonctionnement, la pompe à liquide (15), la vanne de régulation de pression (17) et le vanne des gaz (18) sont dans un état fermé;
    un deuxième mode de fonctionnement, dans lequel la buse de pulvérisation électrostatique (1) fonctionne comme un composant indépendant à mesurer et n'est pas connectée à un pulvérisateur électrostatique externe, le liquide est entraîné par la pompe à liquide (15) pour s'écouler dans une circulation fermée constitué de la buse de pulvérisation électrostatique (1), du cylindre inférieur (7), du tuyau de sortie d'eau de cylindre inférieur (8), de la cuve de stockage d'eau (13) et du tuyau d'alimentation en eau (14), de sorte que la buse de pulvérisation électrostatique (1) s'alimente de manière continue en le liquide à pulvériser et que la poursuite du test de pulvérisation soit assurée, et de plus, la vanne de régulation de pression (17) est commandée pour ajuster une pression de sortie de la pompe à liquide (15) et une pression de pulvérisation de la buse de pulvérisation électrostatique (1), de sorte de réaliser la mesure du paramètre de rapport charge/masse sous différentes pressions de pulvérisation; lorsque le paramètre de rapport charge/masse de la buse de pulvérisation électrostatique (1) est mesuré en le deuxième mode de fonctionnement, la pompe à liquide (15), la vanne de régulation de pression (17) et la vanne des gaz (18) sont dans un état ouvert.

8. Procédé de mesure par le système de mesure du rapport charge/masse de la buse de pulvérisation électrostatique (1) selon la revendication 7, **caractérisé en ce que**,
   lorsque le système de mesure se trouve en le premier mode de fonctionnement, l'ordinateur acquiert en temps réel les données de mesure de l'ampèremètre (9) et de l'indicateur de niveau à ultrasons (12), et le procédé de mesure comprend en particulier les étapes suivantes :

    lors d'un test de pulvérisation de la buse de pulvérisation électrostatique (1), acquérir en temps réel, par l'ordinateur, des données d'un courant I sorties par l'ampèremètre (9) selon une période d'échantillonnage $T_1$ de l'ampèremètre (9), et acquérir en temps réel des données d'une hauteur de niveau de liquide h sorties par l'indicateur de niveau à ultrasons (12) selon une période d'échantillonnage $T_2$ de l'indicateur de niveau à ultrasons (12), une durée d'échantillonnage de l'ordinateur étant t1 comprise entre 30T et 50T, où T est une valeur supérieure de $T_1$ et $T_2$ ;
    lors d'un test du système, acquérir, par l'ordinateur, les données du courant I et de la hauteur de niveau de liquide h pendant la durée d'échantillonnage t1 pour générer respectivement des matrices $I1=[I1_1, I1_2, ..., I1_n]$ et $h1=[h1_1, h1_2, ..., h1_n]$ ; calculer d'abord, par l'ordinateur, des coefficients de fluctuation

$$S1_{h1} = \frac{max(h1) - min(h1)}{\overline{h1}}$$

et $S2_{h1} = \left| \frac{h1_m}{\overline{h1}} \right|$, où max(h1) est une valeur maximum dans la matrice h1, min(h1) est une valeur minimum dans la matrice h1, $\overline{h1} = \frac{\sum_{i=1}^{n} h1_i}{n}$ , et $h1_m$ est une valeur médiane de la matrice h1 ;

lorsque les coefficients de fluctuation $S1_{h1}$ et $S2_{h1}$ satisfont les deux conditions $S1_{h1} \leq 6\%$ et $97\% \leq S2_{h1} \leq 103\%$, traiter, par l'ordinateur, les matrices I1 et h1, acquérir respectivement par calcul les valeurs moyennes $\overline{I1} = \frac{\sum_{i=1}^{n} I1_i}{n}$ et $\overline{h1} = \frac{\sum_{i=1}^{n} h1_i}{n}$ des matrices I1 et h1, et sortir respectivement $\overline{I1}$ et $\overline{h1}$ comme une valeur de courant en temps réel et une hauteur de niveau de liquide en temps réel de ce test de pulvérisation ;

lorsque les coefficients de fluctuation $S1_{h1}$ et $S2_{h1}$ ne satisfont pas à la fois les conditions $S1_{h1} \leq 6\%$ et $97\% \leq S2_{h1} < 103\%$, toujours sortir, par l'ordinateur, $\overline{I1}$ et $\overline{h1}$ comme la valeur de courant en temps réel et la hauteur de niveau de liquide en temps réel de ce test de pulvérisation respectivement, et de plus, sortir les coefficients de fluctuation $S1_{h1}$ et $S2_{h1}$ de manière synchrone comme référence pour des testeurs;

lorsque le système de mesure se trouve en le deuxième mode de fonctionnement, l'ordinateur acquiert en temps réel les données de mesure de l'ampèremètre (9), de l'indicateur de niveau à ultrasons (12) et du débitmètre (20), et le procédé de mesure comprend en particulier les étapes suivantes :

lors du test de pulvérisation de la buse de pulvérisation électrostatique (1), acquérir en temps réel, par l'ordinateur, des données du courant I sorties par l'ampèremètre (9) selon la période d'échantillonnage $T_1$ de l'ampèremètre (9), acquérir en temps réel des données de la hauteur de niveau de liquide h sorties par l'indicateur de niveau à ultrasons (12) selon la période d'échantillonnage $T_2$ de l'indicateur de niveau à ultrasons (12), et acquérir en temps réel des données du débit de pulvérisation q sorties par le débitmètre (20) selon la période d'échantillonnage $T_3$ du débitmètre (20), la durée d'échantillonnage de l'ordinateur étant t2 comprise entre 30T et 50T, où T est une valeur maximum parmi $T_1$, $T_2$, et $T_3$ ;

pendant le test du système, acquérir, par l'ordinateur, les données du courant I, de la hauteur de niveau de liquide h et du débit de pulvérisation q pendant la durée d'échantillonnage t2 pour générer respectivement des matrices I2=[I2$_1$, I2$_2$, ..., I2$_n$], h2=[h2$_1$, h2$_2$, ..., h2$_n$], et q1=[q1$_1$, q1$_2$, .., q1$_n$] ; calculer d'abord, par l'ordinateur, des coefficients de fluctuation $S1_{h2}$ = $\frac{\max(h2) - \min(h2)}{\overline{h2}}$, $S2_{h2} = \left|\frac{h2_m}{\overline{h2}}\right|$, $S1_{q1} = \frac{\max(q1) - \min(q1)}{\overline{q1}}$, et $S2_{q1} = \left|\frac{q1_m}{\overline{q1}}\right|$ des matrices h2 et q1, où max(h2) est la valeur maximum dans la matrice h2, min(h2) est la valeur minimum dans la matrice h2, $\overline{h2} = \frac{\sum_{i=1}^{n} h2_i}{n}$ et $h2_m$ est la valeur médiane de la matrice h2, max(q1) est la valeur maximum dans la matrice q1, min(q1) est la valeur minimum dans la matrice q1, $\overline{q1} = \frac{\sum_{i=1}^{n} q1_i}{n}$ et $q1_m$ est la valeur médiane de la q1 ;

lorsque les coefficients de fluctuation $S1_{h2}$, $S2_{h2}$, $S1_{q1}$ et $S2_{q1}$ satisfont toutes les conditions $S1_{h2} \leq 6\%$, $97\% \leq S2_{h2} \leq 103\%$, $S1_{q1} \leq 3\%$, et $98\% \leq S2_{q1} \leq 102\%$, traiter, par l'ordinateur, les matrices I2 et h2, acquérir respectivement par calcul les valeurs moyennes $\overline{I2} = \frac{\sum_{i=1}^{n} I2_i}{n}$ et $\overline{h2} = \frac{\sum_{i=1}^{n} h2_i}{n}$ des matrices I2 et h2, et sortir respectivement $\overline{I2}$ et $\overline{h2}$ comme la valeur de courant en temps réel et la hauteur de niveau de liquide en temps réel de ce test de pulvérisation ;

lorsque les coefficients de fluctuation $S1_{h2}$, $S2_{h2}$, $S1_{q1}$ et $S2_{q1}$ ne satisfont pas à la fois les conditions $S1_{h2} \leq 6\%$, $97\% \leq S2_{h2} \leq 103\%$, $S1_{q1} \leq 3\%$, et $98\% \leq S2_{q1} \leq 102\%$, toujours sortir, par l'ordinateur, $\overline{I2}$ et $\overline{h2}$ comme la valeur de courant en temps réel et la hauteur de niveau de liquide en temps réel de ce test de pulvérisation respectivement, et de plus, sortir les coefficients de fluctuation $S1_{h2}$, $S2_{h2}$, $S1_{q1}$ et $S2_{q1}$ de manière synchrone comme référence pour des testeurs.

9. Procédé selon la revendication 8, **caractérisé en ce que** lorsque le système de mesure se trouve en le premier mode de fonctionnement ou le deuxième mode de fonctionnement, le système informatique calcule le paramètre de rapport charge/masse de la buse d'atomisation électrostatique (1) en fonction de la valeur de courant en temps réelle et la sortie de hauteur de niveau de liquide en temps réel dans le test de pulvérisation, et le paramètre de rapport charge/masse est en particulier calculé en fonction de la formule suivante:

$$\varepsilon = k_1 \frac{\overline{I1}}{\rho d_1^2 \sqrt{g\overline{h1}}} = k_1 \frac{\overline{I2}}{\rho d_1^2 \sqrt{g\overline{h2}}}$$

où $\varepsilon$, en microcoulombs/kilogramme, est le paramètre de rapport charge/masse de la buse d'atomisation électrostatique (1);

$\rho$, en kilogrammes/mètre cube, est la masse volumique du liquide à pulvériser par la buse de pulvérisation électrostatique (1) ;

$d_1$, en mètres, est le diamètre interne du tuyau de sortie d'eau de cylindre inférieur (8);

g, en mètres/seconde au carré, est l'accélération gravitationnelle;

$k_1$ est un coefficient de correction, $k_1$=1080-1120 ;

$\overline{I1}$ et $\overline{I2}$, en ampères, sont des valeurs de courant en temps réel lors du test du système de mesure ;

$\overline{h1}$ et $\overline{h2}$, en mètres, sont les hauteurs de niveau de liquide en temps réel lors du test du système de mesure.

FIG. 1

FIG. 2

# B-B

27

5

FIG. 3

C-C

FIG. 4

# EP 3 816 640 B1

**REFERENCES CITED IN THE DESCRIPTION**

**Patent documents cited in the description**

- CN 105676010 A
- CN 201210457633
- CN 201310359398
- CN 201310690188
- CN 201610007625X
- CN 201810322387